# EUROPEAN PATENT APPLICATION

(11) **EP 4 726 780 A1**
(43) Date of publication of application: **15.04.2026**
(21) Application number: 24819304.7
(22) Date of filing: 04.06.2024
(51) Int. Cl.: H01L 27/146

(54) **LIGHT DETECTION DEVICE AND ELECTRONIC EQUIPMENT**

(30) Priority: 09.06.2023 JP 2023095803
(71) Applicant: Sony Semiconductor Solutions Corporation, Atsugi-shi, Kanagawa 243-0014 (JP)
(72) Inventor: KIDO, Hideo, Atsugi-shi, Kanagawa 243-0014 (JP); YAMATO, Masaki, Atsugi-shi, Kanagawa 243-0014 (JP)
(74) Representative: MFG Patentanwälte Meyer-Wildhagen Meggle-Freund Gerhard PartG mbB
(86) International application number: PCT/JP2024/020300
(87) International publication number: WO 2024/253074

(57) **Abstract**

A light detecting device according to an embodiment of the present disclosure includes: a first substrate including a plurality of photoelectric conversion elements that each photoelectrically converts light; a second substrate stacked on the first substrate, and including a plurality of readout circuits that is each configured to output a first signal based on electric charge converted by the photoelectric conversion element; a through electrode provided for each of the readout circuits or every plurality of the readout circuits in the second substrate, and configured to transmit the first signal; and a first insulating layer provided to penetrate the second substrate around the through electrode.

## Description

### Technical Field

The present disclosure relates to a light detecting device, and to an electronic apparatus.

### Background Art

An imaging device has been proposed that has a configuration in which a first substrate including a sensor pixel, a second substrate including a readout circuit, and a third substrate including a logic circuit are stacked (PTL 1).

### Citation List

### Patent Literature

PTL 1: International Publication No. WO2020/170936

### Summary of the Invention

It is desired, for a device that detects light, to suppress a decrease in signal quality.

It is desirable to provide a light detecting device that makes it possible to suppress a decrease in signal quality.

A light detecting device according to an embodiment of the present disclosure includes: a first substrate including a plurality of photoelectric conversion elements that each photoelectrically converts light; a second substrate stacked on the first substrate, and including a plurality of readout circuits that is each configured to output a first signal based on electric charge converted by the photoelectric conversion element; a through electrode provided for each of the readout circuits or every plurality of the readout circuits in the second substrate, and configured to transmit the first signal; and a first insulating layer provided to penetrate the second substrate around the through electrode.

A light detecting device according to an embodiment of the present disclosure includes: a first substrate including a plurality of photoelectric conversion elements that each photoelectrically converts light; a second substrate including a plurality of readout circuits, and stacked on the first substrate, the plurality of readout circuits each including an amplification transistor that is configured to generate a first signal based on electric charge converted by the photoelectric conversion element; a through electrode provided for each of the readout circuits or every plurality of the readout circuits in the second substrate, and configured to transmit the first signal; and an insulating layer provided to surround the amplification transistor in the second substrate.

A light detecting device according to an embodiment of the present disclosure includes: a first substrate including a plurality of photoelectric conversion elements that each photoelectrically converts light; a second substrate stacked on the first substrate, and including a plurality of amplification transistors that is each configured to generate a first signal based on electric charge converted by the photoelectric conversion element; a first pixel and a second pixel each including the photoelectric conversion element and the amplification transistor; a first separation region provided to surround the amplification transistor of the first pixel in the second substrate; and a second separation region including at least a portion of the first separation region, and provided to surround the amplification transistor of the second pixel in the second substrate.

An electronic apparatus according to an embodiment of the present disclosure includes: an optical system; and a light detecting device that receives light having passed through the optical system. The light detecting device includes a first substrate including a plurality of photoelectric conversion elements that each photoelectrically converts light, a second substrate stacked on the first substrate, and including a plurality of readout circuits that is each configured to output a first signal based on electric charge converted by the photoelectric conversion element, a through electrode provided for each of the readout circuits or every plurality of the readout circuits in the second substrate, and configured to transmit the first signal, and a first insulating layer provided to penetrate the second substrate around the through electrode.

An electronic apparatus according to an embodiment of the present disclosure includes: an optical system; and a light detecting device that receives light having passed through the optical system. The light detecting device includes: a first substrate including a plurality of photoelectric conversion elements that each photoelectrically converts light, a second substrate including a plurality of readout circuits, and stacked on the first substrate, the plurality of readout circuits each including an amplification transistor that is configured to generate a first signal based on electric charge converted by the photoelectric conversion element, a through electrode provided for each of the readout circuits or every plurality of the readout circuits in the second substrate, and configured to transmit the first signal, and an insulating layer provided to surround the amplification transistor in the second substrate.

### Brief Description of the Drawings

[FIG. 1] FIG. 1 is a block diagram illustrating an example of a schematic configuration of an imaging device that is an example of a light detecting device according to a first embodiment of the present disclosure.
[FIG. 2] FIG. 2 is a diagram illustrating an example of a pixel section of the imaging device according to the first embodiment of the present disclosure.
[FIG. 3] FIG. 3 is an explanatory diagram of an example of a circuit configuration of pixels of the imaging device according to the first embodiment of the present disclosure.
[FIG. 4] FIG. 4 is an explanatory diagram of another example of the circuit configuration of the pixels of the imaging device according to the first embodiment of the present disclosure.
[FIG. 5] FIG. 5 is an explanatory diagram of another example of the circuit configuration of the pixels of the imaging device according to the first embodiment of the present disclosure.
[FIG. 6] FIG. 6 is an explanatory diagram of another example of the circuit configuration of the pixels of the imaging device according to the first embodiment of the present disclosure.
[FIG. 7] FIG. 7 is a diagram illustrating an example of a cross-sectional configuration of the imaging device according to the first embodiment of the present disclosure.
[FIG. 8] FIG. 8 is an explanatory diagram of an example of a planar configuration of the imaging device according to the first embodiment of the present disclosure.
[FIG. 9] FIG. 9 is an explanatory diagram of a configuration example of the imaging device according to the first embodiment of the present disclosure.
[FIG. 10] FIG. 10 is an explanatory diagram of a configuration example of pixels of an imaging device according to a second embodiment of the present disclosure.
[FIG. 11] FIG. 11 is an explanatory diagram of a configuration example of the imaging device according to the second embodiment of the present disclosure.
[FIG. 12] FIG. 12 is an explanatory diagram of a configuration example of the imaging device according to the second embodiment of the present disclosure.
[FIG. 13] FIG. 13 is an explanatory diagram of a configuration example of the imaging device according to the second embodiment of the present disclosure.
[FIG. 14] FIG. 14 is an explanatory diagram of a configuration example of pixels of an imaging device according to a third embodiment of the present disclosure.
[FIG. 15] FIG. 15 is an explanatory diagram of a configuration example of the imaging device according to the third embodiment of the present disclosure.
[FIG. 16] FIG. 16 is an explanatory diagram of a configuration example of the imaging device according to the third embodiment of the present disclosure.
[FIG. 17] FIG. 17 is an explanatory diagram of a configuration example of the imaging device according to the third embodiment of the present disclosure.
[FIG. 18] FIG. 18 is an explanatory diagram of a configuration example of the imaging device according to the third embodiment of the present disclosure.
[FIG. 19] FIG. 19 is an explanatory diagram of an example of a planar configuration of the imaging device according to the third embodiment of the present disclosure.
[FIG. 20] FIG. 20 is an explanatory diagram of an example of a cross-sectional configuration of the imaging device according to the third embodiment of the present disclosure.
[FIG. 21] FIG. 21 is an explanatory diagram of an example of a cross-sectional configuration of an imaging device according to Modification Example 1 of the present disclosure.
[FIG. 22] FIG. 22 is an explanatory diagram of an example of a planar configuration of the imaging device according to Modification Example 1 of the present disclosure.
[FIG. 23] FIG. 23 is an explanatory diagram of another example of the cross-sectional configuration of the imaging device according to Modification Example 1 of the present disclosure.
[FIG. 24] FIG. 24 is an explanatory diagram of an example of a cross-sectional configuration of an imaging device according to Modification Example 2 of the present disclosure.
[FIG. 25] FIG. 25 is an explanatory diagram of an example of a planar configuration of the imaging device according to Modification Example 2 of the present disclosure.
[FIG. 26] FIG. 26 is an explanatory diagram of a configuration example of an imaging device according to Modification Example 3 of the present disclosure.
[FIG. 27] FIG. 27 is an explanatory diagram of a configuration example of an imaging device according to Modification Example 4 of the present disclosure.
[FIG. 28] FIG. 28 is an explanatory diagram of another configuration example of the imaging device according to Modification Example 4 of the present disclosure.
[FIG. 29] FIG. 29 is an explanatory diagram of another configuration example of the imaging device according to Modification Example 4 of the present disclosure.
[FIG. 30] FIG. 30 is an explanatory diagram of another configuration example of the imaging device according to Modification Example 4 of the present disclosure.
[FIG. 31] FIG. 31 is an explanatory diagram of a configuration example of an imaging device according to Modification Example 5 of the present disclosure.
[FIG. 32] FIG. 32 is an explanatory diagram of a configuration example of an imaging device according to Modification Example 6 of the present disclosure.
[FIG. 33] FIG. 33 is an explanatory diagram of a configuration example of an imaging device according to Modification Example 7 of the present disclosure.
[FIG. 34] FIG. 34 is an explanatory diagram of a configuration example of an imaging device according to Modification Example 8 of the present disclosure.
[FIG. 35] FIG. 35 is an explanatory diagram of a configuration example of an imaging device according to Modification Example 9 of the present disclosure.
[FIG. 36] FIG. 36 is an explanatory diagram of a configuration example of the imaging device according to Modification Example 9 of the present disclosure.
[FIG. 37] FIG. 37 is an explanatory diagram of a configuration example of the imaging device according to Modification Example 9 of the present disclosure.
[FIG. 38] FIG. 38 is an explanatory diagram of another configuration example of the imaging device according to Modification Example 9 of the present disclosure.
[FIG. 39] FIG. 39 is an explanatory diagram of a configuration example of an imaging device according to Modification Example 10 of the present disclosure.
[FIG. 40] FIG. 40 is an explanatory diagram of a configuration example of the imaging device according to Modification Example 10 of the present disclosure.
[FIG. 41] FIG. 41 is an explanatory diagram of a configuration example of an imaging device according to Modification Example 11 of the present disclosure.
[FIG. 42] FIG. 42 is an explanatory diagram of another configuration example of the imaging device according to Modification Example 11 of the present disclosure.
[FIG. 43] FIG. 43 is a block diagram illustrating a configuration example of an electronic apparatus including the imaging device.
[FIG. 44] FIG. 44 is a block diagram depicting an example of schematic configuration of a vehicle control system.
[FIG. 45] FIG. 45 is a diagram of assistance in explaining an example of installation positions of an outside-vehicle information detecting section and an imaging section.
[FIG. 46] FIG. 46 is a view depicting an example of a schematic configuration of an endoscopic surgery system.
[FIG. 47] FIG. 47 is a block diagram depicting an example of a functional configuration of a camera head and a camera control unit (CCU).

### Modes for Carrying Out the Invention

Hereinafter, a description is given in detail of embodiments of the present disclosure with reference to the drawings. It is to be noted that the description is given in the following order.
1. First Embodiment
2. Second Embodiment
3. Third Embodiment
4. Modification Examples
5. Application Example
6. Practical Application Examples

### <1. First Embodiment>

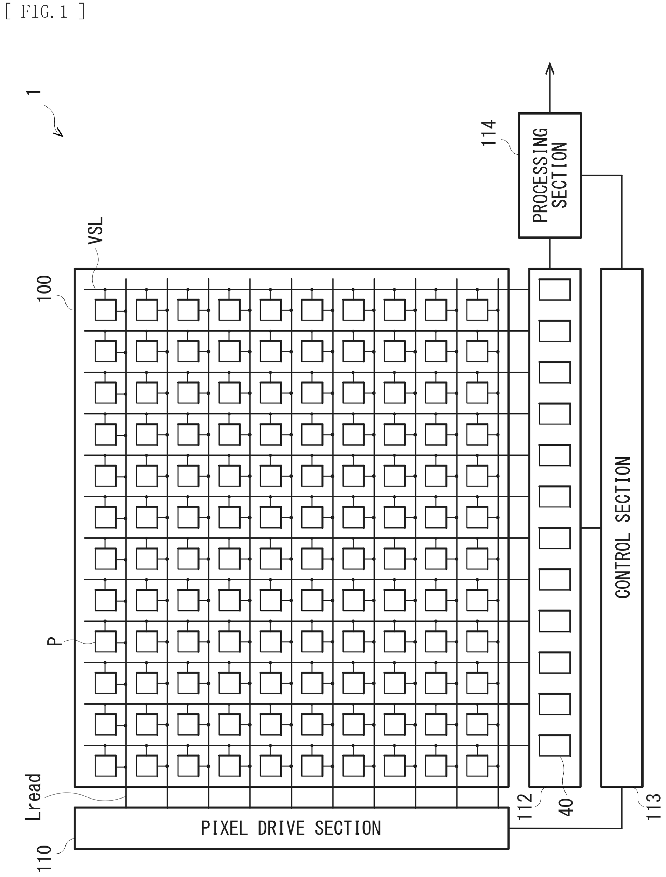

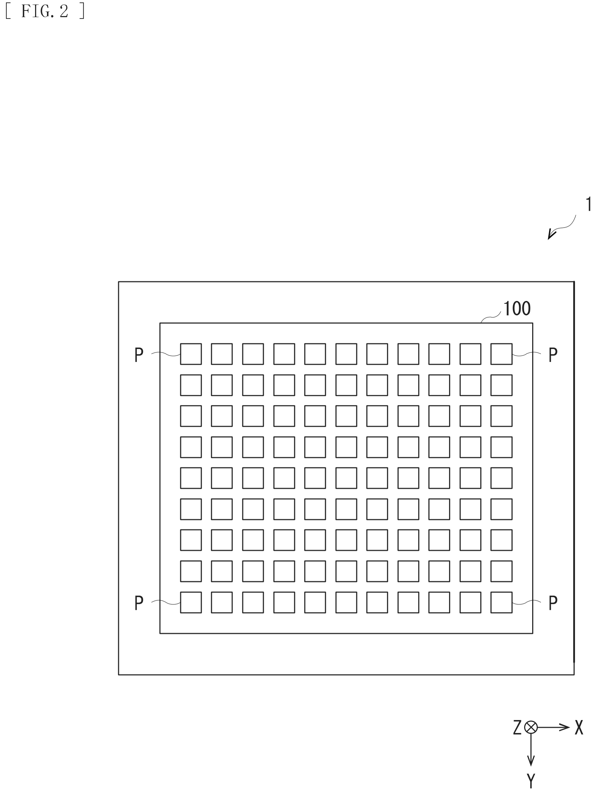

FIG. 1 is a block diagram illustrating an example of a schematic configuration of an imaging device that is an example of a light detecting device according to a first embodiment of the present disclosure. FIG. 2 is a diagram illustrating an example of a pixel section of the imaging device according to the first embodiment. The light detecting device is a device that is able to detect incident light. An imaging device 1, which is a light detecting device, includes a plurality of pixels P each including a photoelectric conversion section (a photoelectric conversion element), and is configured to generate a signal by photoelectrically converting incident light. The imaging device 1 (the light detecting device) is able to receive light having passed through an optical system (not illustrated) including an optical lens and generate a signal.

The imaging device 1 is configured using, for example, a semiconductor substrate (e.g., a silicon substrate) provided with the plurality of pixels P. The photoelectric conversion section of each of the pixels P of the imaging device 1 is, for example, a photodiode (PD), and is configured to be able to photoelectrically convert light. As illustrated in FIG. 2, the imaging device 1 includes, as an imaging area, a region (a pixel section 100) in which the plurality of pixels P is two-dimensionally arranged in a matrix. The pixel section 100 is a pixel array in which the plurality of pixels P is arranged, and may also be referred to as a light-receiving region.

The imaging device 1 takes in incident light (image light) from a subject via the optical system including the optical lens. The imaging device 1 captures an image of the subject formed by the optical lens. The imaging device 1 may photoelectrically convert received light to generate a pixel signal. The imaging device 1 is, for example, a CMOS (Complementary Metal Oxide Semiconductor) image sensor. The imaging device 1 is usable for an electronic apparatus such as a digital still camera, a video camera, or a mobile phone.

It is to be noted that, as illustrated in FIG. 2, a direction in which light from the subject is incident is defined as a Z-axis direction; a right-left direction on the sheet orthogonal to the Z-axis direction is defined as an X-axis direction; and an up-down direction on the sheet orthogonal to the Z-axis direction and the X-axis direction is defined as a Y-axis direction. In the following drawings, the arrow directions in FIG. 2 may be used, in some cases, as a standard to express a direction.

The imaging device 1 has a structure (a stacking structure) configured by stacking a plurality of substrates, as will be described later. As in the example illustrated in FIG. 1, the imaging device 1 includes, for example, a pixel drive section 110, a signal processing section 112, a control section 113, a processing section 114, and the like. In addition, the imaging device 1 is provided with a plurality of control lines Lread and a plurality of signal lines VSL.

The control lines Lread are signal lines that are each able to transmit a signal that controls the pixel P, and are coupled to the pixel drive section 110 and the pixels P of the pixel section 100. In the example illustrated in FIG. 1, a plurality of control lines Lread is wired for each pixel row configured by a plurality of pixels P arranged in a horizontal direction (a row direction) in the pixel section 100. The control lines Lread are each configured to transmit a control signal for readout of a signal from the pixel P.

The plurality of control lines Lread for respective pixel rows of the imaging device 1 includes, for example, a wiring that transmits a signal that controls a transfer transistor, a wiring that transmits a signal that controls a selection transistor, a wiring that transmits a signal that controls a reset transistor, and the like. The control lines Lread may also be referred to as drive lines (pixel drive lines) that each transmit a signal that drives the pixel P.

The signal lines VSL are signal lines that are each able to transmit a signal from the pixel P, and are coupled to the pixels P of the pixel section 100 and the signal processing section 112. In the pixel section 100, for example, one or a plurality of signal lines VSL is wired for each pixel column configured by a plurality of pixels P arranged in a vertical direction (a column direction).

The signal lines VSL are each configured to transmit a signal outputted from the pixel P. In the imaging device 1, a plurality of signal lines VSL may be provided for one pixel column. The imaging device 1 includes, for example, a plurality of signal lines VSL for each pixel column. The signal lines VSL may each be configured using a through electrode, a via, or the like, as will be described later.

The pixel drive section 110 is configured to be able to drive each of the pixels P of the pixel section 100. The pixel drive section 110 is a drive circuit, and is configured by a plurality of circuits including a buffer, a shift register, an address decoder, and the like, for example. The pixel drive section 110 generates a signal for driving the pixel P, and outputs the generated signal to each of the pixels P of the pixel section 100 via the control line Lread. The pixel drive section 110 is controlled by the control section 113, and controls the pixels P of the pixel section 100.

The pixel drive section 110 generates, for example, a signal that controls the pixel P, such as a signal that controls a transfer transistor of the pixel P, a signal that controls a selection transistor, or a signal that controls a reset transistor, and supplies the generated signal to each of the pixels P by the control line Lread. The pixel drive section 110 may perform control to read a pixel signal from each of the pixels P. The pixel drive section 110 may also be referred to as a pixel control section configured to be able to control each of the pixels P. It is to be noted that the pixel drive section 110 and the control section 113 can also be collectively referred to as a pixel control section.

The signal processing section 112 is configured to be able to execute signal processing on an inputted pixel signal. The signal processing section 112 is a signal processing circuit, and includes, for example, a load circuit section, an AD converter 40, a horizontal selection switch, and the like. The load circuit section is configured by, for example, a current source that is able to supply a current to an amplification transistor of the pixel P. The load circuit section configures, for example, a source-follower circuit together with the amplification transistor of the pixel P. It is to be noted that the signal processing section 112 may include an amplification circuit section configured to amplify a signal read from the pixel P via the signal line VSL.

The signal processing section 112 includes a plurality of AD converters 40 (AD conversion circuits), and may output a pixel signal having been converted into a digital signal by the AD converter 40. The AD converters 40 are ADCs (Analog to Digital Converters). The AD converters 40 are each provided for a corresponding one of the plurality of signal lines VSL, for example. The AD converters 40 may be provided for respective pixel columns of the pixel section 100.

The AD converter 40 is configured to convert an inputted analog signal into a digital signal. The AD converter 40 performs AD conversion processing on the pixel signal, which is an analog signal, inputted from each of the pixels P via the signal line VSL. The AD converter 40 (the AD conversion circuit) includes, for example, a comparison circuit (a comparator circuit) and a counter, and may convert the inputted pixel signal into a digital signal of a predetermined bit number.

The signal outputted from each of the pixels P selectively scanned by the pixel drive section 110 is inputted to the signal processing section 112 via the signal line VSL. The signal processing section 112 may perform, for example, signal processing such as AD conversion of a signal of the pixel P or CDS (Correlated Double Sampling: correlated double sampling). The signal of each of the pixels P transmitted through each of the signal lines VSL is subjected to signal processing by the signal processing section 112, and is outputted to the processing section 114.

The processing section 114 is configured to be able to execute signal processing on an inputted signal. The processing section 114 is a processing circuit, and is configured by, for example, a circuit that performs various kinds of signal processing on the pixel signal. The processing section 114 may include a processor and a memory. The processing section 114 performs signal processing on the pixel signal inputted from the signal processing section 112, and outputs the processed pixel signal. The processing section 114 may perform, for example, various kinds of signal processing such as noise reduction processing or gray-scale correction processing.

The control section 113 is configured to be able to control each section of the imaging device 1. The control section 113 may receive a clock applied from the outside, data commanding an operation mode, or the like, and output data such as internal information on the imaging device 1. The control section 113 is a control circuit, and includes, for example, a timing generator configured to be able to generate various timing signals.

The control section 113 controls driving of the pixel drive section 110, the signal processing section 112, and the like on the basis of the various timing signals (pulse signals, clock signals, etc.) generated by the timing generator. It is to be noted that the pixel drive section 110, the signal processing section 112, the control section 113, the processing section 114, and the like may be provided in one semiconductor substrate, or may be provided separately in a plurality of semiconductor substrates. A part or all of the signal processing section 112, the control section 113, and the processing section 114 may be integrally configured.

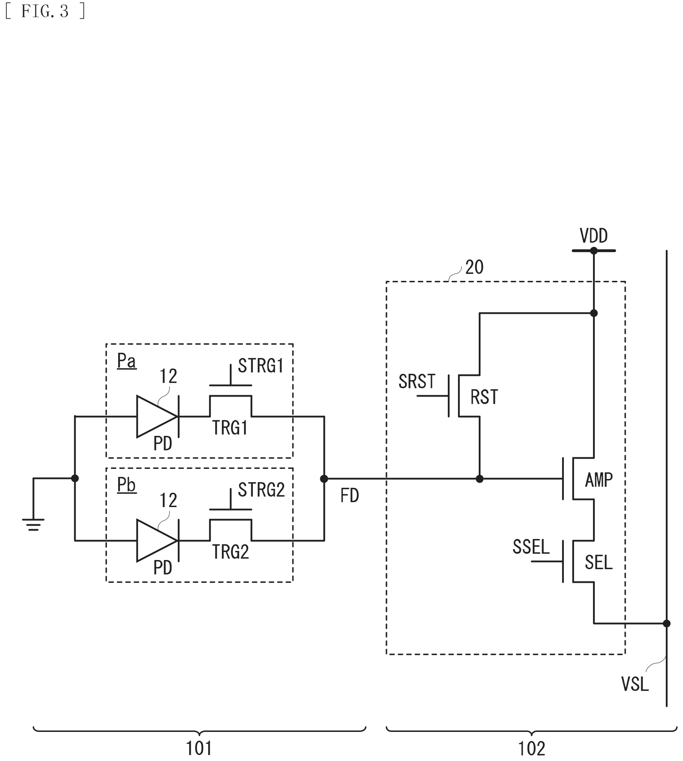

FIG. 3 is an explanatory diagram of an example of a circuit configuration of pixels of the imaging device according to the first embodiment. The pixel P of the imaging device 1 includes a photoelectric conversion section 12 (a photoelectric conversion element), a transfer transistor TRG, a floating diffusion FD, and a readout circuit 20. The photoelectric conversion section 12 is configured to receive light and generate a signal. The photoelectric conversion section 12 is a light-receiving section (a light-receiving element), and is configured to be able to generate electric charge by photoelectric conversion.

The readout circuit 20 is configured to be able to output a signal based on photoelectrically converted electric charge. In the imaging device 1, the readout circuit 20 is provided for a plurality of pixels P, for example. The imaging device 1 has a configuration in which one readout circuit 20 is shared by a plurality of pixels P.

In the example illustrated in FIG. 3, the readout circuit 20 is disposed for every two pixels P (which are referred to as a pixel Pa and a pixel Pb). The pixel Pa and the pixel Pb shares one readout circuit 20. For example, 2 × 1 pixels including the pixel Pa and the pixel Pb adjacent to each other share one readout circuit 20. The plurality of pixels P sharing one readout circuit 20 may also be referred to as a pixel unit (or a pixel block).

The imaging device 1 may operate the readout circuit 20 time-divisionally to thereby read respective pixel signals of the 2 × 1 pixels. In addition, the imaging device 1 is also able to read pixel signals to which the respective signals of the 2 × 1 pixels are added. For example, the imaging device 1 may read a pixel signal corresponding to electric charge to which electric charge of the pixel Pa photoelectrically converted by the photoelectric conversion section 12 and electric charge of the pixel Pb photoelectrically converted by the photoelectric conversion section 12 are added.

In the example illustrated in FIG. 3, the photoelectric conversion section 12 is a photodiode (PD), and converts incident light into electric charge. The photoelectric conversion sections 12 (the photodiode PD of the pixel Pa and the photodiode PD of the pixel Pb in FIG. 3) may each perform photoelectric conversion to generate electric charge corresponding to an amount of received light.

The transfer transistors TRG (a transfer transistor TRG1 of the pixel Pa and a transfer transistor TRG2 of the pixel Pb in FIG. 3) are each configured to be able to transfer the electric charge photoelectrically converted by the photoelectric conversion section 12 to the floating diffusion FD. The transfer transistor TRG is controlled by a signal STRG, and electrically couples or decouples the photoelectric conversion section 12 and the floating diffusion FD to or from each other. The transfer transistor TRG may transfer the electric charge photoelectrically converted by and accumulated in the photoelectric conversion section 12 to the floating diffusion FD.

In the example illustrated in FIG. 3, the transfer transistors TRG of the pixel Pa and the pixel Pb are controlled by signals different from each other. The transfer transistor TRG1 of the pixel Pa is controlled ON/OFF by a signal STRG1. In addition, the transfer transistor TRG2 of the pixel Pb is controlled ON/OFF by a signal STRG2.

The floating diffusion FD is an accumulation section, and is configured to be able to accumulate the transferred electric charge. The floating diffusion FD may accumulate the electric charge photoelectrically converted by the photoelectric conversion section 12. The floating diffusion FD may also be referred to as a holding section that is able to hold the transferred electric charge. The floating diffusion FD accumulates the transferred electric charge, and converts the electric charge into a voltage corresponding to a capacitance of the floating diffusion FD.

As an example, as illustrated in FIG. 3, the readout circuit 20 includes an amplification transistor AMP, a selection transistor SEL, and a reset transistor RST. The amplification transistor AMP is configured to generate and output a signal based on the electric charge accumulated in the floating diffusion FD. The amplification transistor AMP may generate and output a signal based on the electric charge converted by the photoelectric conversion section 12.

As illustrated in FIG. 3, a gate of the amplification transistor AMP is electrically coupled to the floating diffusion FD, and receives an input of a voltage converted by the floating diffusion FD. A drain of the amplification transistor AMP is coupled to a power supply line to be supplied with a power supply voltage VDD.

A source of the amplification transistor AMP is coupled to the signal line VSL via the selection transistor SEL. The amplification transistor AMP may generate a signal based on the electric charge accumulated in the floating diffusion FD, i.e., a signal based on the voltage of the floating diffusion FD and output the generated signal to the signal line VSL.

The selection transistor SEL is configured to be able to control the output of the pixel signal. The selection transistor SEL is controlled by a signal SSEL, and is configured to be able to output the signal from the amplification transistor AMP to the signal line VSL. The selection transistor SEL may control an output timing of the pixel signal. The selection transistor SEL is configured to be able to output the signal based on the electric charge converted by the photoelectric conversion section 12.

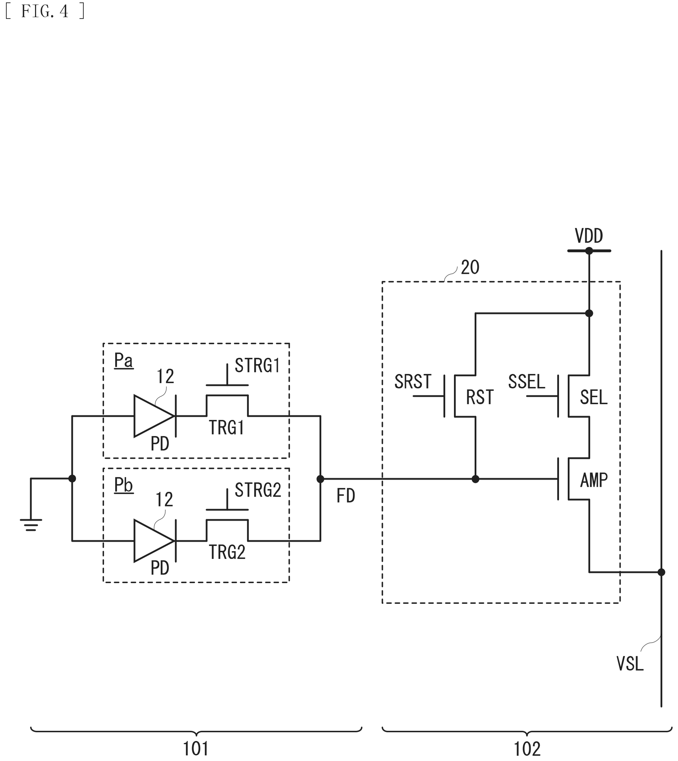

It is to be noted that, as in an example illustrated in FIG. 4, the selection transistor SEL may be provided between the power supply line to be supplied with the power supply voltage VDD, and the amplification transistor AMP. In the example illustrated in FIG. 4, the drain of the amplification transistor AMP is coupled to the power supply line to be supplied with the power supply voltage VDD via the selection transistor SEL. The source of the amplification transistor AMP is coupled to the signal line VSL. It is to be noted that the selection transistor SEL may be omitted as needed.

The reset transistor RST is configured to be able to reset the voltage of the floating diffusion FD. In the example illustrated in FIG. 3 or FIG. 4, the reset transistor RST is electrically coupled to the power supply line to be supplied with the power supply voltage VDD, and is configured to reset the electric charge of the pixel P.

The reset transistor RST may be controlled by a signal SRST to reset the electric charge accumulated in the floating diffusion FD and to reset the voltage of the floating diffusion FD. It is to be noted that the reset transistor RST may discharge the electric charge accumulated in the photoelectric conversion section 12 via the transfer transistor TRG.

The transfer transistor TRG, the amplification transistor AMP, the selection transistor SEL, and the reset transistor RST, which are described above, are each a MOS transistor (MOSFET) having terminals of a gate, a source, and a drain. In the examples illustrated in FIG. 3 and the like, the transfer transistor TRG, the amplification transistor AMP, the selection transistor SEL, and the reset transistor RST are each configured by an NMOS transistor. It is to be noted that the transistors of the pixel P may each be configured by a PMOS transistor.

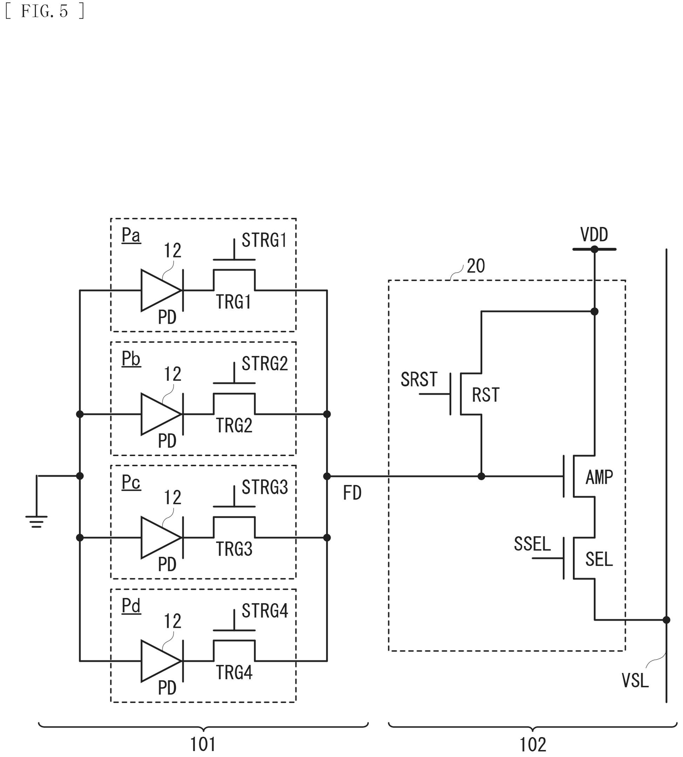

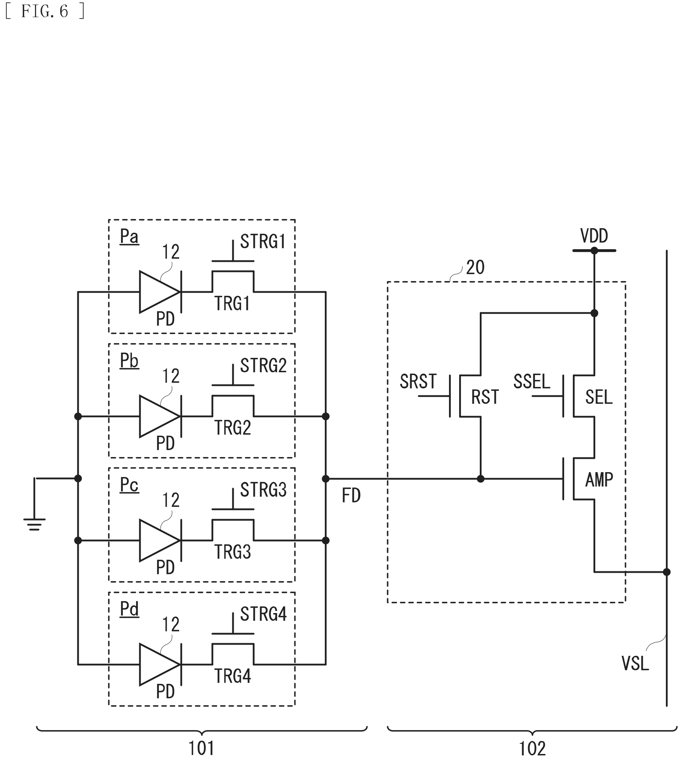

The imaging device 1 may have a configuration in which three or more pixels P share one readout circuit 20. For example, as in an example illustrated in FIG. 5, the readout circuit 20 is disposed for every four pixels P (that are referred to as pixels Pa to Pd). It is to be noted that, as in an example illustrated in FIG. 6, the selection transistor SEL may be electrically coupled between the power supply line and the amplification transistor AMP. In addition, the selection transistor SEL may be omitted as needed.

In the example illustrated in FIG. 5 or FIG. 6, the pixel Pa, the pixel Pb, the pixel Pc, and the pixel Pd share one readout circuit 20. For example, a pixel unit including 2 × 2 pixels that include the pixels Pa to Pd adjacent to each other shares one readout circuit. It is to be noted that the imaging device 1 may have a configuration in which five or more pixels P, e.g., eight pixels P share one readout circuit 20.

The pixel drive section 110 (see FIG. 1) supplies a control signal to gates of the transfer transistor TRG, the selection transistor SEL, the reset transistor RST, and the like of each of the pixels P via the control line Lread described above to bring the transistors into an ON state (electrically-conductive state) or an OFF state (non-electrically-conductive state).

The plurality of control lines Lread of the imaging device 1 includes a wiring that transmits the signal STRG that controls the transfer transistor TRG, a wiring that transmits the signal SSEL that controls the selection transistor SEL, a wiring that transmits the signal SRST that controls the reset transistor RST, and the like.

The transfer transistor TRG, the selection transistor SEL, the reset transistor RST, and the like are controlled ON/OFF by the pixel drive section 110. The pixel drive section 110 controls the readout circuit 20 of each of the pixels P to thereby allow the pixel signal to be outputted from each of the pixels P to the signal line VSL. The pixel drive section 110 may perform control to read the pixel signal of each of the pixels P to the signal line VSL.

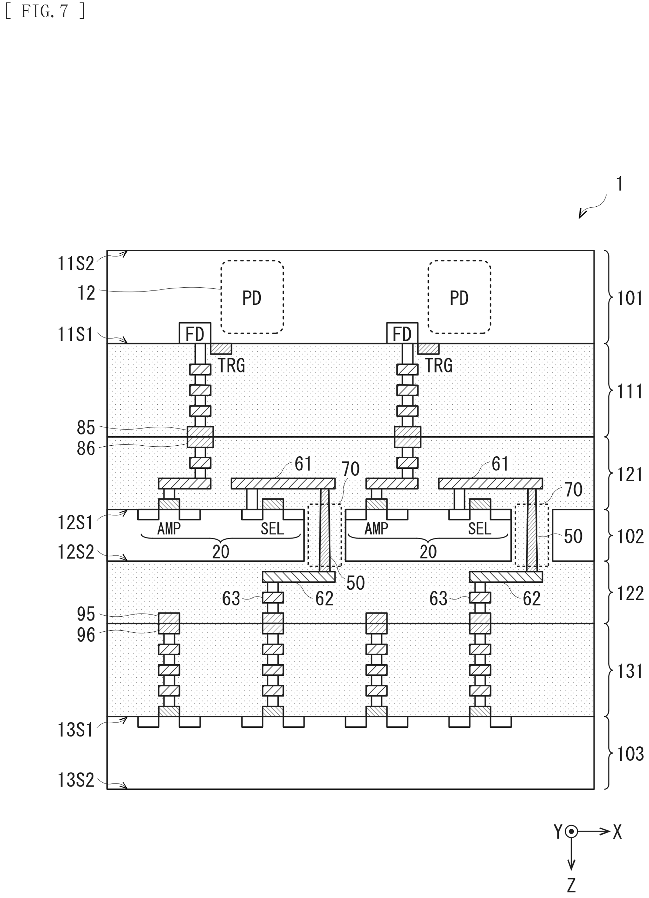

FIG. 7 is a diagram illustrating an example of a cross-sectional configuration of the imaging device according to the first embodiment. The imaging device 1 includes, for example, a first substrate 101, a second substrate 102, and a third substrate 103, as in the example illustrated in FIG. 7. The imaging device 1 has a configuration in which the first substrate 101, the second substrate 102, and the third substrate 103 are stacked in the Z-axis direction.

The first substrate 101, the second substrate 102, and the third substrate 103 are provided from a light incident side. The first substrate 101, the second substrate 102, and the third substrate 103 are each configured by a semiconductor substrate (e.g., a silicon substrate, an SOI (Silicon On Insulator) substrate, etc.).

The first substrate 101 has a surface 11S1 and a surface 11S2 opposed to each other, as illustrated in FIG. 7. The surface 11S2 is a surface on a side opposite to the surface 11S1. The surface 11S2 of the first substrate 101 is a light-receiving surface (a light incident surface). In the first substrate 101, a plurality of photoelectric conversion sections 12 (photoelectric conversion elements) is provided along the surface 11S1 and the surface 11S2 of the first substrate 101. For example, the plurality of photoelectric conversion sections 12 is formed to be embedded in the first substrate 101.

The second substrate 102 has a surface 12S1 and a surface 12S2 opposed to each other. The surface 12S2 is a surface on a side opposite to the surface 12S1. In addition, the third substrate 103 has a surface 13S1 and a surface 13S2 opposed to each other. The surface 13S2 is a surface on a side opposite to the surface 13S1. The surfaces 11S1, 12S1, and 13S1 are each, for example, an element formation surface on which an element such as a transistor is formed. Each of the surfaces 11S1, 12S1, and 13S1 may be provided with a gate electrode, a gate insulating film (e.g., a gate oxide film), or the like.

FIG. 7 illustrates the transfer transistor TRG, the amplification transistor AMP, the selection transistor SEL, and the like of the pixel P described above. The transfer transistor TRG and the floating diffusion FD are formed on a side of the surface 11S1 of the first substrate 101. Each of the transistors (including the amplification transistor AMP, the selection transistor SEL, the reset transistor RST, and the like) of the readout circuit 20 of the pixel P is provided on a side of the surface 12S1 of the second substrate 102.

A wiring layer 111 is provided on the side of the surface 11S1 of the first substrate 101, as illustrated in FIG. 7. In addition, a wiring layer 121 is provided on the side of the surface 12S1 of the second substrate 102, and a wiring layer 122 is provided on a side of the surface 12S2 of the second substrate 102. A wiring layer 131 is provided on a side of the surface 13S1 of the third substrate 103. The wiring layers 111, 121, 122, and 131 each include, for example, a conductive film and an insulating film, and each have a plurality of wirings, a via (VIA), and the like.

The wiring layers 111, 121, 122, and 131 each have a configuration in which the plurality of wirings is stacked with an insulating film (an interlayer insulating film) interposed therebetween. The insulating film of each of the wiring layers 111, 121, 122, and 131 may also be referred to as an interlayer insulating film (an interlayer insulating layer). As an example, the wiring layers 111, 121, 122, and 131 each include wirings of two or more layers. The wiring layers 122 and 131 may include wirings of three or more layers.

The wirings of the wiring layers 111, 121, 122, and 131 are each formed using, for example, a metal material such as aluminum (Al), copper (Cu), or tungsten (W). The wirings of the wiring layers 111, 121, 122, and 131 may be configured using polysilicon, or another electrically-conductive material. The interlayer insulating film is formed using, for example, silicon oxide (SiO), silicon nitride (SiN), silicon oxynitride (SiON), or the like.

It is to be noted that the first substrate 101 and the wiring layer 111 can also be collectively referred to as the first substrate 101 (or a first circuit layer). In addition, the second substrate 102 and the wiring layers 121 and 122 can also be collectively referred to as the second substrate 102 (or a second circuit layer). Furthermore, the third substrate 103 and the wiring layer 131 can also be collectively referred to as the third substrate 103 (or a third circuit layer).

The wiring layer 111 is provided with a plurality of electrodes 85, and the wiring layer 121 is provided with a plurality of electrodes 86. In addition, the wiring layer 122 is provided with a plurality of electrodes 95, and the wiring layer 131 is provided with a plurality of electrodes 96. The electrodes 85, the electrodes 86, the electrodes 95, and the electrode 96 are each, for example, an electrode formed using copper (Cu).

The electrodes 85, 86, 95, and 96 are each an electrode to be used for bonding between metal electrodes, and may also each be referred to as a bonding electrode. As an example, the first substrate 101 and the second substrate 102 are attached to each other by bonding between metal electrodes (the electrode 85 and the electrode 86) including Cu, i.e., by Cu-Cu bonding.

The first substrate 101 and the second substrate 102 are stacked by bonding between electrodes so as to cause the surface 11S1 on which an element such as a transistor is formed and the surface 12S1 on which an element such as a transistor is formed to be opposed to each other. In other words, the first substrate 101 and the second substrate 102 are bonded to each other so as to cause a front surface of the first substrate 101 and a front surface of the second substrate 102 to be opposed each other. A circuit provided on a side of the first substrate 101 and a circuit provided on a side of the second substrate 102 are electrically coupled to each other by the electrode 85 and the electrode 86.

In addition, the second substrate 102 and the third substrate 103 are attached to each other by bonding between the electrode 95 and the electrode 96 including Cu, i.e., by Cu-Cu bonding. The second substrate 102 and the third substrate 103 are stacked by bonding between electrodes so as to cause the surface 12S2 and the surface 13S1 to be opposed to each other. In other words, the second substrate 102 and the third substrate 103 are bonded to each other so as to cause a back surface of the second substrate 102 and a front surface of the third substrate 103 to be opposed each other.

A circuit of the second substrate 102 and a circuit of the third substrate 103 are electrically coupled to each other by the electrode 95 and the electrode 96. The third substrate 103 and the wiring layer 131 may be provided with, for example, the pixel drive section 110, the signal processing section 112, the control section 113, the processing section 114, and the like that are described above.

It is to be noted that the electrodes 85, 86, 95, and 96 may each be configured by a metal material other than copper, e.g., by nickel (Ni), cobalt (Co), gold (Au), or the like, or may be configured by another material. In addition, a bump may be used to stack the first substrate 101, the second substrate 102, and the third substrate 103.

In the imaging device 1, the photoelectric conversion section 12, the transfer transistor TRG, and the floating diffusion FD of each of the pixels P are provided in the first substrate 101. In addition, each of the transistors (the amplification transistor AMP, the selection transistor SEL, the reset transistor RST, and the like) of the readout circuit 20 is provided in the second substrate 102.

The floating diffusion FD of the pixel P of the first substrate 101 is electrically coupled to the amplification transistor AMP, the reset transistor RST, and the like of the readout circuit 20 of the second substrate 102 via the wiring of the wiring layer 111 and the wiring of the wiring layer 121, as in the example illustrated in FIG. 7. Electric charge photoelectrically converted by the photoelectric conversion section 12 of the first substrate 101 may be transferred to the floating diffusion FD of the first substrate 101 and the readout circuit 20 of the second substrate 102 via the transfer transistor TRG.

The readout circuit 20 may generate a pixel signal based on the electric charge converted by the photoelectric conversion section 12 and output the pixel signal to the signal processing section 112 of the third substrate 103 via the signal line VSL including a through electrode to be described later. As described above, in the imaging device 1, the photoelectric conversion section 12 and the readout circuit 20 are disposed in different substrates. This allows the imaging device 1 to have a structure that is advantageous to pixel miniaturization.

The second substrate 102 and the wiring layers 121 and 122 of the imaging device 1 include a plurality of through electrodes 50, as illustrated in FIG. 7. For example, a plurality of through electrodes 50 is provided for each of the pixels P or for every plurality of pixels P, for example. The through electrodes 50 are each a coupling electrode (a coupling section), and couple circuits provided in different layers to each other. The through electrodes 50 are provided to penetrate the second substrate 102.

As an example, the through electrodes 50 are each formed to reach the surface 12S2 of the second substrate 102 between a plurality of readout circuits 20 adjacent to each other, and penetrate the second substrate 102. The through electrodes 50 are each an electrode that penetrates the second substrate 102. The through electrodes 50 are each formed to extend in the Z-axis direction and reach within the wiring layer 122.

The through electrodes 50 are configured by, for example, tungsten (W), aluminum (Al), copper (Cu), or the like. The through electrodes 50 may be formed using cobalt (Co), molybdenum (Mo), ruthenium (Ru), silver (Ag), or the like. The through electrode 50 may be configured by another metal material.

In the imaging device 1, the readout circuit 20 of the pixel P is electrically coupled to the wiring provided on the side of the surface 12S2 of the second substrate 102 and a circuit provided in the third substrate 103 by the through electrode 50. In the example illustrated in FIG. 7, the readout circuit 20 of the pixel P is electrically coupled to the circuit of the third substrate 103 via the through electrode 50, and the electrode 95 and the electrode 96 for bonding.

The signal line VSL of the imaging device 1 includes the through electrode 50, and is configured to be able to transmit the pixel signal. The through electrode 50 that transmits the pixel signal may be provided for each of the readout circuits 20 or every plurality of readout circuits 20. The through electrode 50 configuring a portion of the signal line VSL is disposed for the selection transistor SEL of the readout circuit 20, for example.

As illustrated in FIG. 7, the signal line VSL includes a wiring 61 provided in the wiring layer 121, and wirings 62 and 63 provided in the wiring layer 122. In the example illustrated in FIG. 7, the through electrode 50 that is a portion of the signal line VSL is electrically coupled to the selection transistor SEL via the wiring 61, and is electrically coupled to the wiring 63 via the wiring 62. As an example, the wiring 63 is wired along a direction where pixels of a pixel column are arranged in the wiring layer 122.

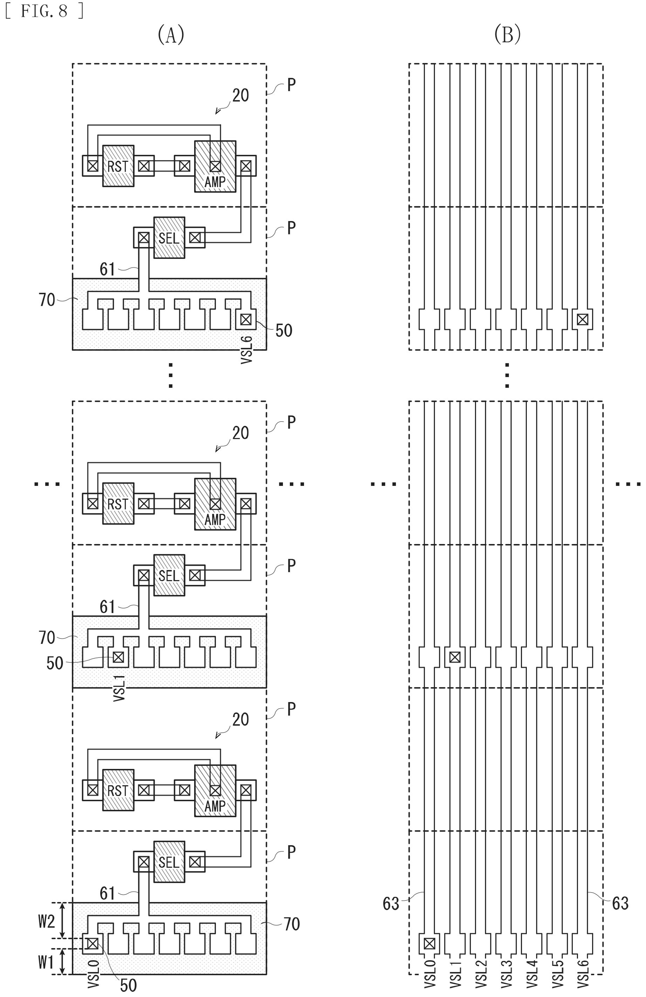

FIG. 8 is an explanatory diagram of an example of a planar configuration of the imaging device according to the first embodiment. (A) of FIG. 8 illustrates an example of a planar configuration in the second substrate 102 and the wiring layer 121 of the imaging device 1. (B) of FIG. 8 illustrates an example of a planar configuration in the wiring layer 122 of the imaging device 1.

As an example, the readout circuit 20 is provided for a region of two pixels P that share the readout circuit 20, as illustrated in the example in FIG. 8. It is to be noted that the readout circuit 20 may be provided for a region of 2 × 2 pixels that share the readout circuit 20. The selection transistors SEL of a plurality of readout circuit 20 are electrically coupled to the wiring 63 formed in the wiring layer 122 via the wiring 61, the through electrode 50, and the like, as illustrated in (A) and (B) of FIG. 8.

The wiring 63 is provided to extend in the column direction (e.g., the Y-axis direction), for example. In the imaging device 1, a plurality of wirings 63 corresponding to a plurality of signal lines VSL (signal lines VSL0 to VSL6 in (B) of FIG. 8) may be disposed for a pixel column. Providing the plurality of signal lines VSL makes it possible to transmit pixel signals simultaneously (in parallel) from a plurality of readout circuits 20 in the pixel column.

The readout circuit 20 of the pixel P is electrically coupled to the signal processing section 112 including the AD converter 40 provided in the third substrate 103 via the signal line VSL that is a signal line using the through electrode 50 as described above. The pixel signal outputted from the amplification transistor AMP of the pixel P is inputted to the AD converter 40 of the signal processing section 112 via the wiring 61, the through electrode 50, the wirings 62 and 63, the electrodes 95 and 96, and the like.

As described above, in the imaging device 1 according to the present embodiment, the signal line VSL is wired to reach the side of the surface 12S2 of the second substrate 102 by the through electrode 50 and extend in a predetermined direction (e.g., the column direction) in the wiring layer 122 on the side of the surface 12S2. This makes it possible to prevent an increase in number of layers of wirings in the wiring layer 121 on the side of the surface 12S1.

Reducing the number of layers of wirings in the wiring layer 121 makes it possible to reduce a height of the wiring layer 121, and makes it possible to shorten a distance (a spacing) between the floating diffusion FD of the first substrate 101 and the amplification transistor AMP of the second substrate 102. Accordingly, it is possible to reduce an interconnect capacitance to be added to the floating diffusion FD in the wiring layer 121. As a result, it is possible to improve conversion efficiency (a conversion gain) when converting electric charge into a voltage in the floating diffusion FD.

In the imaging device 1 according to the present embodiment, it is possible to separate the signal line VSL from the floating diffusion FD, and it is possible to reduce an unnecessary parasitic capacitance formed between the signal line VSL and the floating diffusion FD. It is possible to suppress noise mixing to the pixel signal, thus making it possible to suppress a decrease in quality of the pixel signal. It is possible to suppress a decrease in image quality of an image.

In addition, as illustrated in FIGs. 7 and 8, the imaging device 1 is provided with an insulating layer 70. The insulating layer 70 is provided to penetrate the second substrate 102 around the through electrode 50. The insulating layer 70 has, for example, a trench (a groove). The insulating layer 70 is configured using an insulating material, and is disposed around the through electrode 50 in the second substrate 102. It can also be said that the insulating layer 70 is provided in the second substrate 102, and is disposed in place of a portion of the second substrate 102.

The insulating layer 70 is provided to be adjacent to the through electrode 50, for example, as in the example illustrated in FIGs. 7 and 8. In the imaging device 1, for example, a plurality of insulating layers 70 may be formed to surround each of the plurality of through electrodes 50. In the example illustrated in FIG. 8, the insulating layers 70 are provided to surround each of the plurality of through electrodes 50 in a plan view. The insulating layer 70 has a predetermined thickness, and may be provided to surround the through electrode 50 on all sides.

The insulating layer 70 may be provided between the transistor (e.g., the selection transistor SEL or the amplification transistor AMP) of the readout circuit 20 and the through electrode 50 that configures a portion of the signal line VSL. For example, at least a portion of the insulating layer 70 is provided between the through electrode 50 as the signal line VSL and the selection transistor SEL, and the through electrode 50 is positioned apart from the selection transistor SEL.

The insulating layer 70 is formed between the transistor of the readout circuit 20 and the through electrode 50, and has a predetermined width W (a width W1 and a width W2 in FIG. 8). As an example, the width W1 and the width W2 illustrated in FIG. 8 may each be greater than or equal to 200 nm and less than or equal to 1 µm. The widths W1 and W2 of the insulating layer 70 may each be greater than or equal to 300 nm, or may each be greater than or equal to 400 nm.

The insulating layer 70 is formed using, for example, an insulating material such as silicon oxide (SiO), silicon nitride (SiN), aluminum oxide (AlO), or a resin material. The insulating layer 70 may be configured by SiOC, SiOCH, or the like that is a low-dielectric constant material (a Low-k material). The insulating layer 70 may be configured by SiOF, porous silica, or the like, or may be configured using another material. It is to be noted that the insulating layer 70 may be configured by a single-layer film including one of the materials described above, or a stacked film including two or more of the materials described above.

As described above, in the imaging device 1 according to the present embodiment, the insulating layer 70 is provided around the through electrode 50. It is possible to reduce a parasitic capacitance formed for the through electrode 50 serving as the signal line VSL. It is possible to reduce an unnecessary parasitic capacitance to be added to the signal line VSL, and it is possible to improve transmission characteristics of the pixel signal. For example, it is possible to suppress signal delay in the signal line VSL, a decrease in signal level, a decrease in frame rate, and the like. In addition, it is possible to suppress mixing of a noise component to the pixel signal, thus making it possible to suppress a decrease in signal quality.

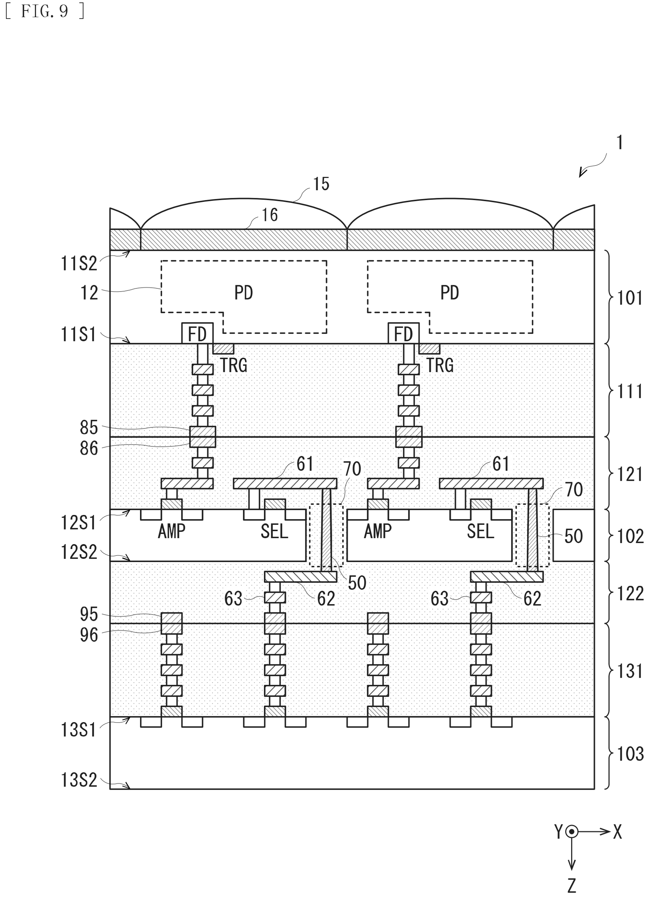

FIG. 9 is an explanatory diagram of a configuration example of the imaging device according to the first embodiment of the present disclosure. The imaging device 1 may include a lens 15 and a filter 16, as in the example illustrated in FIG. 9. The lens 15 and the filter 16 are provided on a side of the surface 11S2 of the first substrate 101, for example. The lens 15 guides light incident from above to a side of the photoelectric conversion section 12. The lens 15 (a lens section) is an optical member that is also referred to as an on-chip lens.

The lens 15 is provided above the photoelectric conversion section 12 for each of the pixels P or for every plurality of pixels P, for example. Light from a subject is incident on the lens 15 via an optical system such as an imaging lens. The photoelectric conversion section 12 of the pixel P photoelectrically converts light incident via the lens 15.

The filter 16 is configured to allow light of a specific wavelength region of incident light to selectively pass therethrough. The filter 16 is a color filter of RGB, and is provided between the lens 15 and the photoelectric conversion section 12. The filter 16 is disposed above the photoelectric conversion section 12 for each of the pixels P or for every plurality of pixels P, for example. It is to be noted that the filter 16 provided for each of the pixels P of the pixel portion 100 may be a color filter of a complementary color system, a filter that allows infrared light to pass therethrough, or the like.

### [Workings and Effects]

The light detecting device according to the present embodiment includes a first substrate (the first substrate 101) including a plurality of photoelectric conversion elements (the photoelectric conversion sections 12) that each photoelectrically converts light; a second substrate (the second substrate 102) stacked on the first substrate, and including a plurality of readout circuits (readout circuits 20), the plurality of readout circuits each configured to output a first signal based on electric charge converted by the photoelectric conversion element; a through electrode (the through electrode 20) provided for each of the readout circuits or every plurality of readout circuits in the second substrate and configured to transmit the first signal; and a first insulating layer (the insulating layer 70) provided to penetrate the second substrate around the through electrode.

In the light detecting device (the imaging device 1) according to the present embodiment, the insulating layer 70 is provided to penetrate the second substrate 102 around the through electrode 50 that is able to transmit a pixel signal. This makes it possible to reduce an unnecessary parasitic capacitance to be added to the through electrode 50 serving as the signal line VSL. It is possible to achieve a light detecting device that makes it possible to suppress a decrease in signal quality.

### <2. Second Embodiment>

A description is given next of a second embodiment of the present disclosure. Hereinafter, components similar to those in the embodiment described above are denoted by the same reference numerals, and descriptions thereof are omitted as appropriate.

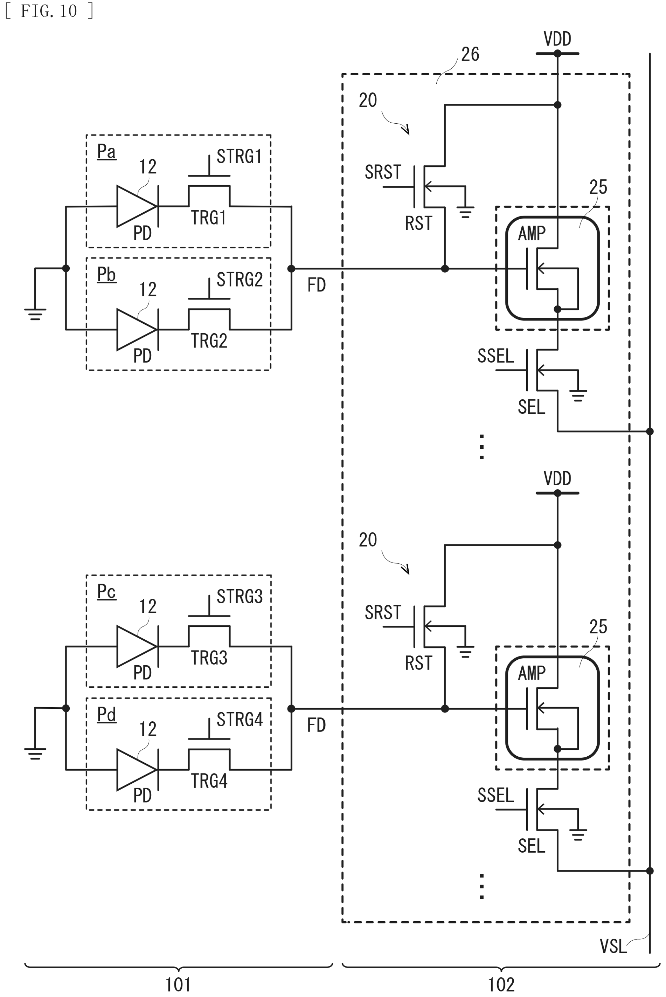

FIG. 10 is an explanatory diagram of a configuration example of pixels of an imaging device according to the second embodiment of the present disclosure. In the imaging device 1 according to the present embodiment, the amplification transistor AMP and other transistors of the readout circuit 20 are provided separately in different wells (a well 25 and a well 26 in FIG. 10).

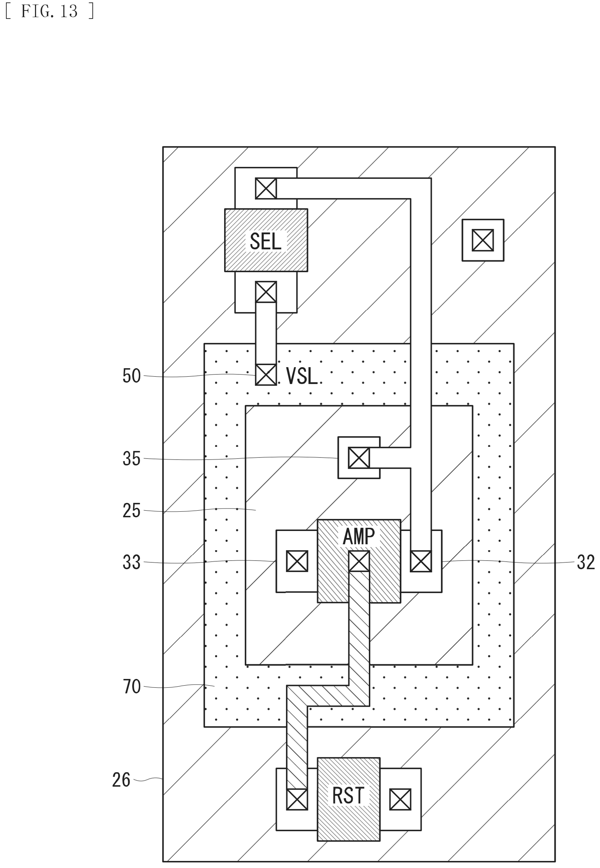

As schematically illustrated in FIG. 10, the amplification transistor AMP of the readout circuit 20 is provided in the well 25. In the imaging device 1, as an example, the well 25 is provided for each of the amplification transistors AMP. For example, in the second substrate 102 of the imaging device 1, one well 25 may be formed for one amplification transistor AMP. The selection transistor SEL and the reset transistor RST of the readout circuit 20 are provided in the well 26. A source region and a drain region of the selection transistor SEL and a source region and a drain region of the reset transistor RST are each provided in the well 26 (see also FIG. 13).

A backgate of the amplification transistor AMP is electrically coupled to the source of the amplification transistor AMP. In this case, it is possible to prevent a backgate effect from occurring in the amplification transistor AMP, and it is possible to improve conversion efficiency. The amplification transistor AMP may also be referred to as a lossless amplifier transistor. For example, it is possible to set a gain of a source-follower circuit including the amplification transistor AMP to 1, and it is possible to suppress a decrease in quality of the pixel signal.

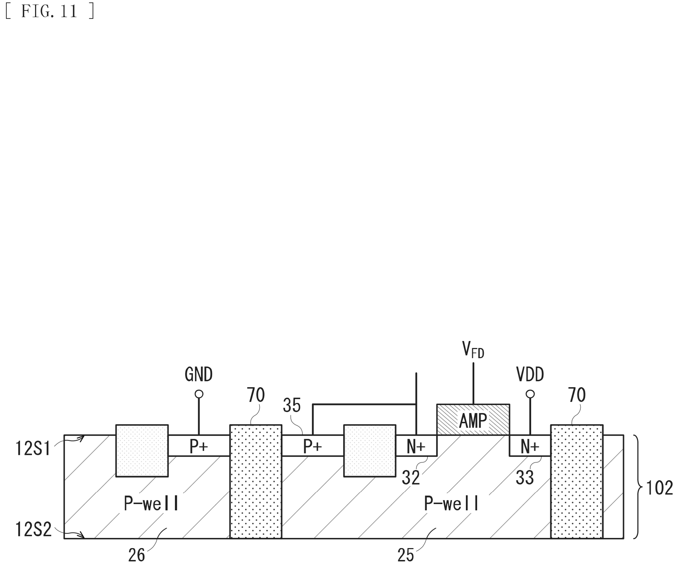

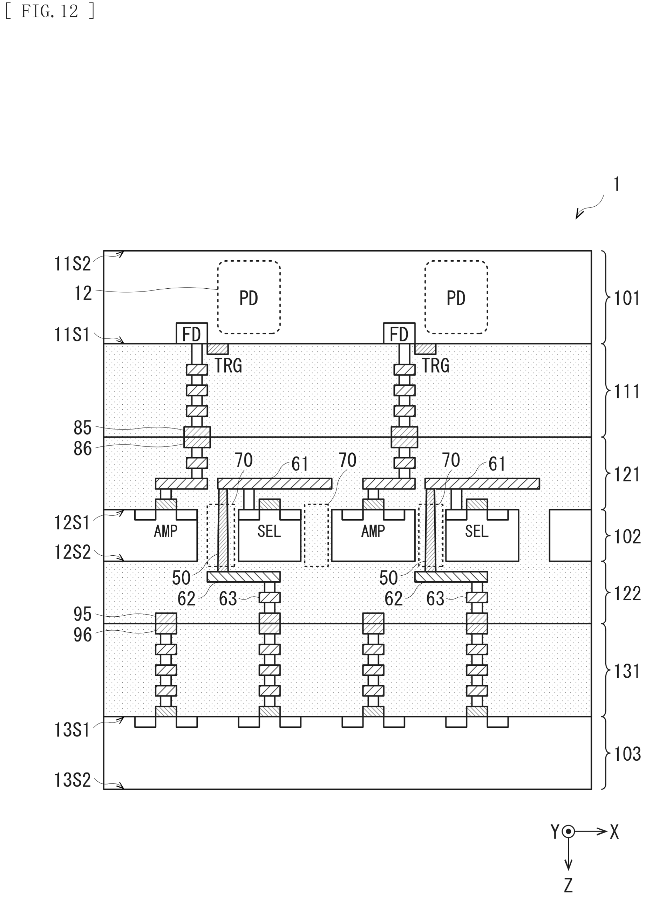

FIGs. 11 to 13 are each an explanatory diagram of a configuration example of the imaging device according to the second embodiment. FIG. 11 illustrates an example of a cross-sectional configuration in the second substrate 102 of the imaging device 1. In addition, FIG. 12 illustrates an example of a cross-sectional configuration of the imaging device 1. In addition, FIG. 13 illustrates an example of a planar configuration in the second substrate 102 of the imaging device 1.

As illustrated in FIG. 11, the well 25 and the well 26 are each, for example, a p-type semiconductor region, and are each a p-type well (a p-well). The well 25 and the well 26 that are p-type well regions are provided in the second substrate 102. The insulating layer 70 is provided between the well 25 and the well 26, and electrically separates the well 25 and the well 26 from each other.

The insulating layer 70 is provided to surround the amplification transistor AMP in the second substrate 102, as in the example illustrated in FIGs. 11 to 13. In addition, the insulating layer 70 is provided around the through electrode 50 as in a case of the first embodiment. The insulating layer 70 provided around the through electrode 50 also serves as a separation section that separates the well 25 and the well 26 from each other.

The insulating layer 70 is configured using a trench (a groove), for example. The insulating layer 70 has an FTI (Full Trench Isolation) structure, and is formed to penetrate the second substrate 102. The insulating layer 70 is provided to surround the well 25 in the second substrate 102. As an example, an insulating film, e.g., a silicon oxide film or an aluminum oxide film, is provided in the trench. The insulating layer 70 may be formed using another insulating material having a low refractive index.

A semiconductor region 35 is provided on the side of the surface 12S1 of the second substrate 102. The semiconductor region 35 is a semiconductor region of the same electrically conductive type as that of the well 25. The semiconductor region 35 has, for example, a higher impurity concentration than an impurity concentration of the well 25, and is a p+-type semiconductor region.

The semiconductor region 35 that is the p+-type semiconductor region is a p+-type diffusion region, and may also be referred to as a p+-type electrically-conductive region. The semiconductor region 35 is a well contact region, and is disposed for each well 25, for example. The semiconductor region 35 may configure a portion of the backgate of the amplification transistor AMP. In addition, the amplification transistor AMP includes a semiconductor region 32 and a semiconductor region 33.

The semiconductor region 32 is a source region of the amplification transistor AMP. In addition, the semiconductor region 33 is a drain region of the amplification transistor AMP. The semiconductor region 32 and the semiconductor region 33 each have a higher impurity concentration than the impurity concentration of the well 25, and is an n+-type semiconductor region. The semiconductor region 33 serving as the drain region of the amplification transistor AMP is electrically coupled to the power supply line to be supplied with the power supply voltage VDD.

The semiconductor region 32 serving as the source region of the amplification transistor AMP is electrically coupled to the semiconductor region 35, as in the example illustrated in FIGs. 11 and 13. In other words, the source of the amplification transistor AMP and the backgate of the amplification transistor AMP are electrically coupled to each other. This makes it possible to suppress threshold voltage variation of the amplification transistor AMP.

In the imaging device 1, the readout circuit 20 may generate and output a pixel signal by the amplification transistor AMP having a lossless amplifier structure. This makes it possible to reduce a decrease in quality of the pixel signal. It is possible to suppress noise mixing to the pixel signal, thus making it possible to suppress a decrease in image quality of an image.

### [Workings and Effects]

The light detecting device according to the present embodiment includes a first substrate (the first substrate 101) including a plurality of photoelectric conversion elements (the photoelectric conversion sections 12) that each photoelectrically converts light; a second substrate (the second substrate 102) including a plurality of readout circuits (readout circuits 20), and stacked on the first substrate, the plurality of readout circuits each including an amplification transistor that is configured to generate a first signal based on electric charge converted by the photoelectric conversion element; a through electrode (the through electrode 50) provided for each of the readout circuits or every plurality of readout circuits in the second substrate, and configured to transmit the first signal; and an insulating layer (the insulating layer 70) provided to surround the amplification transistor in the second substrate.

In the light detecting device (the imaging device 1) according to the present embodiment, the insulating layer 70 is provided to surround the amplification transistor AMP in the second substrate 102. This makes it possible to separate the well 25 of the amplification transistor AMP from another well, and makes it possible to improve characteristics of the amplification transistor AMP. It is possible to achieve a light detecting device that makes it possible to suppress a decrease in signal quality.

### <3. Third Embodiment>

A description is given next of a third embodiment of the present disclosure. Hereinafter, components similar to those in the embodiments described above are denoted by the same reference numerals, and descriptions thereof are omitted as appropriate.

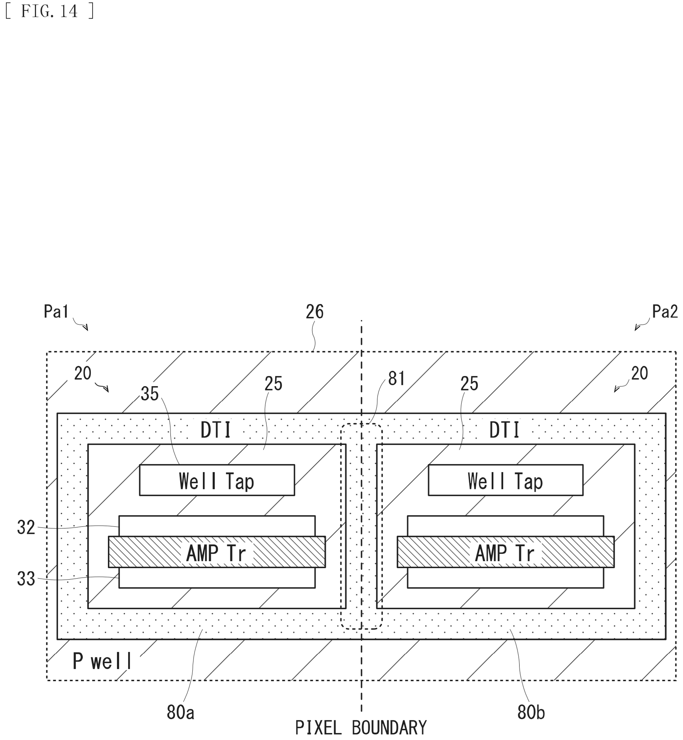

FIG. 14 is an explanatory diagram of a configuration example of pixels of an imaging device according to the third embodiment of the present disclosure. The imaging device 1 includes a separation region 80 provided around the amplification transistor AMP. The separation region 80 (a separation section) is configured using a trench (a groove), for example, and is provided to surround the amplification transistor AMP in the second substrate 102.

The amplification transistor AMP of the readout circuit 20 is provided in the well 25 surrounded by the separation region 80. Other transistors (e.g., the selection transistor SEL and the reset transistor RST) of the readout circuit 20 are provided in the well 26 outside the separation region 80 that surrounds the well 25. The well 25 and the well 26 are each a p-type well, for example. The separation region 80 is provided between the well 25 and the well 26, and electrically separates the well 25 and the well 26 from each other.

The amplification transistor AMP includes the semiconductor region 32 and the semiconductor region 33. For example, the semiconductor region 32 serving as the source region of the amplification transistor AMP and the semiconductor region 33 serving as the drain region of the amplification transistor AMP are each an n+-type semiconductor region, and are each provided in the well 25.

The semiconductor region 35 is a semiconductor region of the same electrically conductive type as that of the well 25, e.g., a p+-type semiconductor region. The semiconductor region 35 is disposed as a well contact region for each well 25, for example. The semiconductor region 35 may configure a portion of the backgate of the amplification transistor AMP.

The imaging device 1 has a configuration in which a plurality of pixels P (or pixel units) shares at least a portion of the separation region 80. FIG. 14 illustrates the separation region 80 (a separation region 80a) provided for the amplification transistor AMP of a pixel Pal of two pixels P adjacent to each other (which are referred to as pixels Pa1 and Pa2). In addition, FIG. 14 also illustrates the separation region 80 (a separation region 80b) provided for the amplification transistor AMP of the pixel Pa2.

The separation region 80a and the separation region 80b are integrally configured, and have, for example, a shared portion 71. The separation region 80b includes the portion 71 that is also a portion of the separation region 80a, and is provided to surround the amplification transistor AMP of the pixel Pa2. The separation region 80a includes the portion 71 that is also a portion of the separation region 80b, and is provided to surround the amplification transistor AMP of the pixel Pa1.

The imaging device 1 has, for example, a configuration in which the portion 71 is shared by two pixels P (the pixels Pa1 and Pa2 in FIG. 14) adjacent to each other in the X-axis direction (or the Y-axis direction) in the pixel section 100 (see FIG. 2 and the like). As an example, the imaging device 1 has a configuration in which the portion 71 is shared by the pixel Pa1 and the pixel Pa2 adjacent to each other in a gate width direction of the amplification transistor AMP.

The separation region 80a and the separation region 80b may be continuously formed and integrally provided. In the example illustrated in FIG. 14, the separation region 80a and the separation region 80b are provided continuously at a boundary between the pixel Pa1 and the pixel Pa2. The separation regions 80 (the separation regions 80a and 80b in FIG. 14) each have, for example, a DTI (Deep Trench Isolation) structure. It is to be noted that the separation region 80a and the separation region 80b can also be collectively referred to as the separation region.

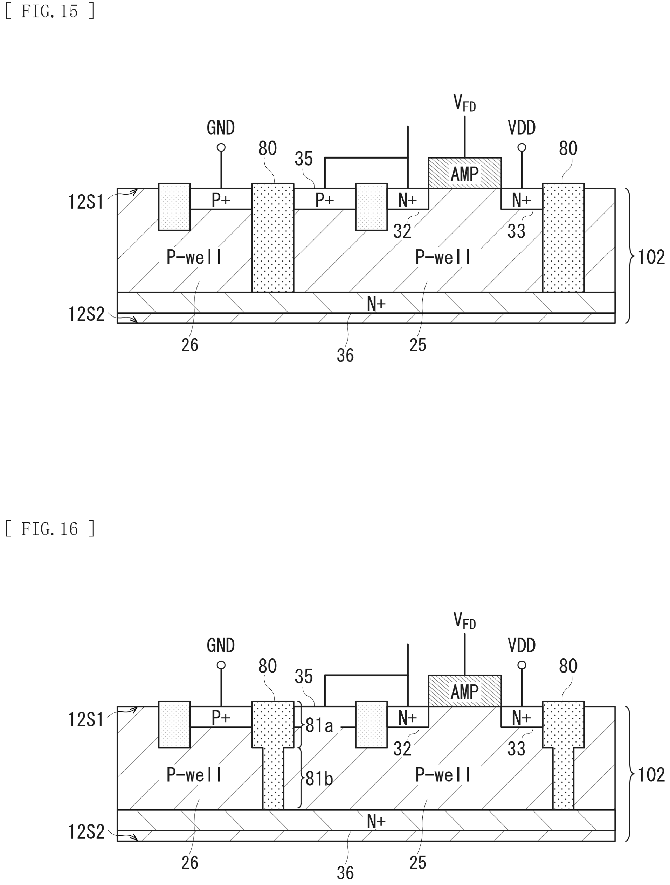

The separation region 80 is provided from the surface 12S1 of the second substrate 102 to between the surface 12S1 and the surface 12S2 of the second substrate 102, as in an example illustrated in FIG. 15. The separation region 80 (i.e., a trench) is disposed to surround the semiconductor region 32 and the semiconductor region 33 of the amplification transistor AMP, and the semiconductor region 35 in the second substrate 102.

In addition, the imaging device 1 may include a semiconductor region 36 provided in the second substrate 102. The semiconductor region 36 is a semiconductor region of an electrically conductive type different from that of the well 25, and is formed on the side of the surface 12S2 of the second substrate 102. The semiconductor region 36 is a region formed using an impurity, e.g., an n-type semiconductor region.

As an example, the semiconductor region 36 has a higher impurity concentration than the impurity concentration of the well 25, and is an n+-type semiconductor region. , For example, as in the example illustrated in FIG. 15, the semiconductor region 36 is disposed in contact with the separation region 80, and is positioned below the well 25 and the well 26 in the second substrate 102. The well 25 and the well 26 are electrically separated from each other by the separation region 80 and the semiconductor region 36.

As an example, a silicon oxide film (SiO₂) is provided in the trench of the separation region 80. Another insulating film, e.g., a silicon nitride film, a silicon oxynitride film, or an aluminum oxide film, may be embedded in the trench of the separation region 80. The separation region 80 may be formed using another insulting material. The trench of the separation region 80 may be filled with polysilicon, a metal material, or the like.

The separation region 80 may be configured using polysilicon (Poly-Si) or silicon nitride (SiN). The separation region 80 may be configured by filling the trench of the separation region 80 with a polysilicon film or a silicon nitride film. Using polysilicon or silicon nitride as a filling material makes it possible to suppress formation of a crack in the separation region 80.

The separation region 80 may include a portion 81a and a portion 81b, as in an example illustrated in FIG. 16. For example, the portion 81a of the separation region 80 is provided on the side of the surface 12S1 of the second substrate 102. In addition, the portion 81b of the separation region 80 is provided to reach the semiconductor region 36 from below the portion 81a.

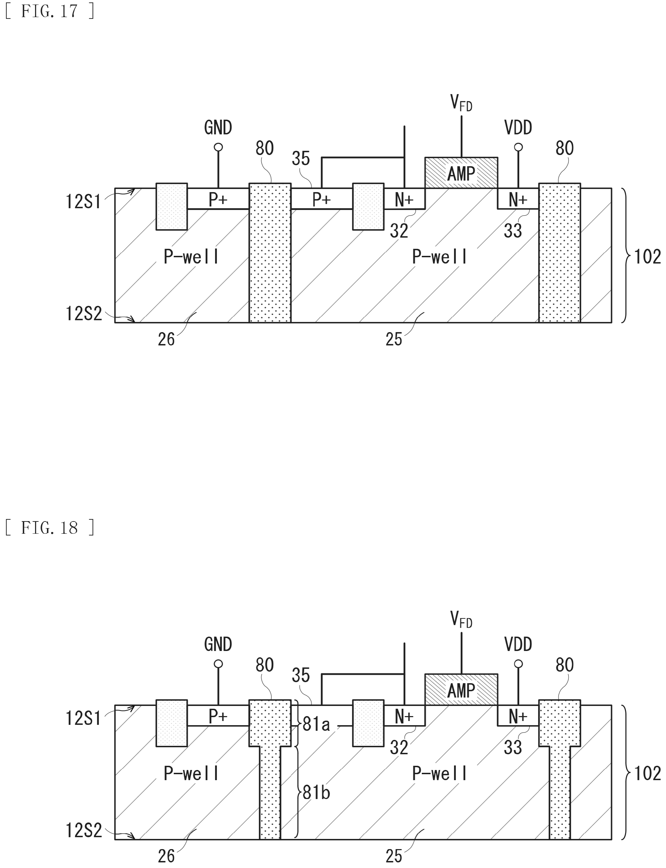

The separation region 80 may be provided to reach the surface 12S2 of the second substrate 102, as in an example illustrated in FIG. 17 or FIG. 18. The separation region 80 is provided to penetrate the second substrate 102. In the example illustrated in FIG. 18, the portion 81b of the separation region 80 is formed from a bottom (a lower end) of the portion 81a to the surface 12S2 of the second substrate 102.

For example, as in the example illustrated in FIG. 15 and the like, the semiconductor region 32 serving as the source region of the amplification transistor AMP is electrically coupled to the semiconductor region 35. In other words, the source of the amplification transistor AMP and the backgate of the amplification transistor AMP are electrically coupled to each other. The amplification transistor AMP is configured as a lossless amplifier, which makes it possible to suppress noise mixing to the pixel signal.

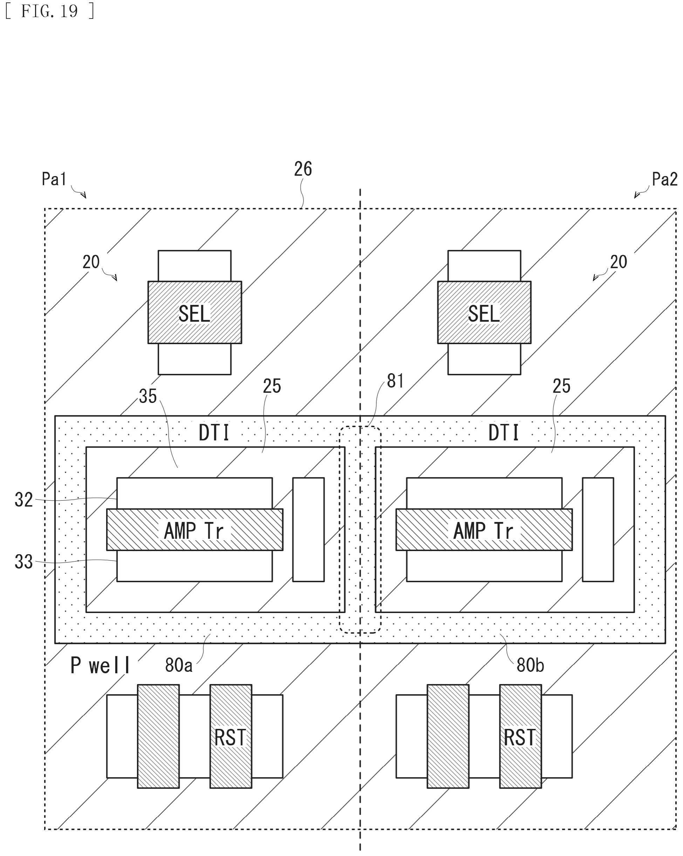

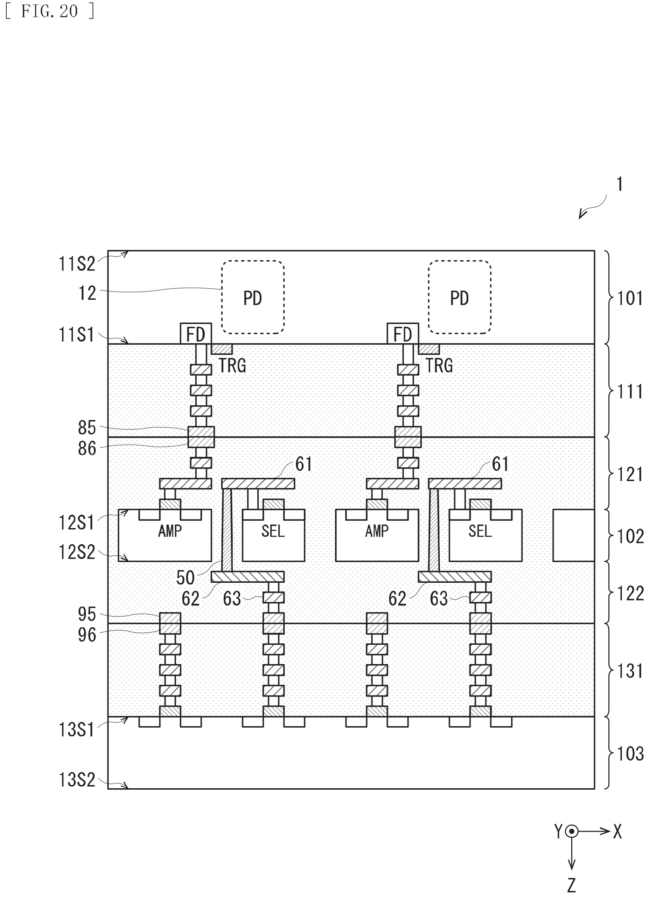

FIG. 19 is an explanatory diagram of an example of a planar configuration of the imaging device according to the third embodiment. FIG. 19 illustrates an example of a planar configuration in the second substrate 102 of the imaging device 1. In addition, FIG. 20 is an explanatory diagram of an example of a cross-sectional configuration of the imaging device. The imaging device 1 according to the present embodiment may have, for example, a configuration in which two or three or more semiconductor layers are stacked.

For example, as in the example illustrated in FIG. 19 or FIG. 20, the selection transistor SEL and the reset transistor RST of the readout circuit 20 are provided in a region around the amplification transistor AMP in the second substrate 102. The source region and the drain region of the selection transistor SEL and the source region and the drain region of the reset transistor RST are each formed in the well 26.

The imaging device 1 according to the present embodiment has a configuration in which a plurality of pixels P shares at least a portion of the separation region 80, as described above. This makes it possible to widen (expand) a region where the amplification transistor AMP is disposed in the pixel P. It is possible to increase a gate width of the amplification transistor AMP as in the example illustrated in FIG. 19, and it is possible to reduce random noise to be mixed to the pixel signal.

In the present embodiment, it is possible to configure the amplification transistor AMP as a lossless amplifier, and to increase the gate width of the amplification transistor AMP. This makes it possible to effectively suppress noise mixing to the pixel signal, and to suppress a decrease in quality of the pixel signal. It is possible to suppress a decrease in image quality of an image.

### [Workings and Effects]

The light detecting device according to the present embodiment includes a first substrate (the first substrate 101) including a plurality of photoelectric conversion elements (the photoelectric conversion sections 12) that each photoelectrically converts light; a second substrate (the second substrate 102) stacked on the first substrate, and including a plurality of amplification transistors that is each configured to generate a first signal based on electric charge converted by the photoelectric conversion element; a first pixel and a second pixel (e.g., the pixels Pa1 and Pa2) each including the photoelectric conversion element and the amplification transistor; a first separation region (the separation region 80a) provided to surround the amplification transistor of the first pixel in the second substrate; and a second separation region (the separation region 80b) including at least a portion of the first separation region, and provided to surround the amplification transistor of the second pixel in the second substrate.

In the light detecting device (the imaging device 1) according to the present embodiment, the separation region 80b includes the portion 71 of the separation region 80a, and is provided to surround the amplification transistor AMP of the pixel Pa2. It is possible to increase the gate width of the amplification transistor AMP, and it is possible to improve characteristics of the amplification transistor AMP. It is possible to achieve a light detecting device that makes it possible to suppress a decrease in signal quality.

A description is given next of modification examples of the present disclosure. Hereinafter, components similar to those in the embodiments described above are denoted by the same reference numerals, and descriptions thereof are omitted as appropriate.

### <4. Modification Examples>

### (4-1. Modification Example 1)

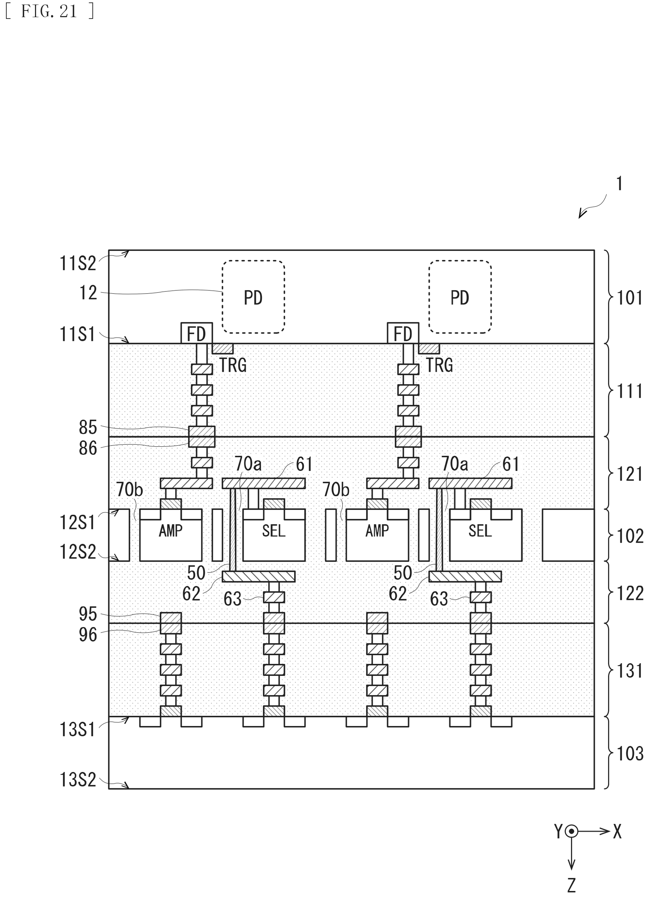

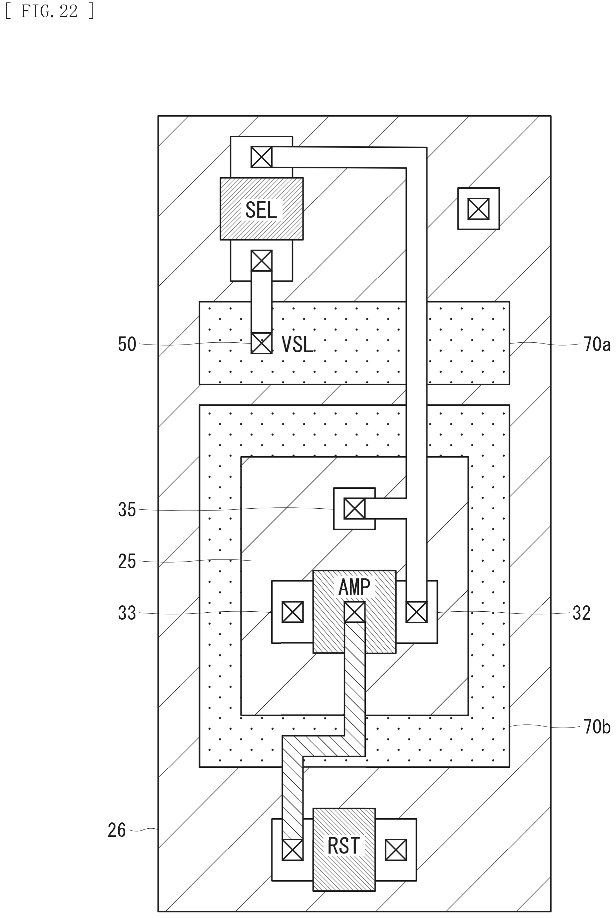

The description has been given, in the embodiments described above, of the configuration examples of the imaging device 1; however, the configuration examples are merely examples, and the configuration of the imaging device 1 is not limited to the examples described above. FIG. 21 is an explanatory diagram of an example of a cross-sectional configuration of an imaging device according to Modification Example 1 of the present disclosure. In addition, FIG. 22 is an explanatory diagram of an example of a planar configuration of the imaging device according to Modification Example 1.

The imaging device 1 may include the insulating layer 70 (an insulating layer 70a) that is provided around the through electrode 50, and the insulating layer 70 (an insulating layer 70b) that electrically separates wells from each other. For example, as in the example illustrated in FIGs. 21 and 22, the imaging device 1 includes the insulating layer 70a for the through electrode 50 and the insulating layer 70b for well separation. , For example, as in the example illustrated in FIG. 22, the insulating layer 70a may be provided outside the insulating layer 70b.

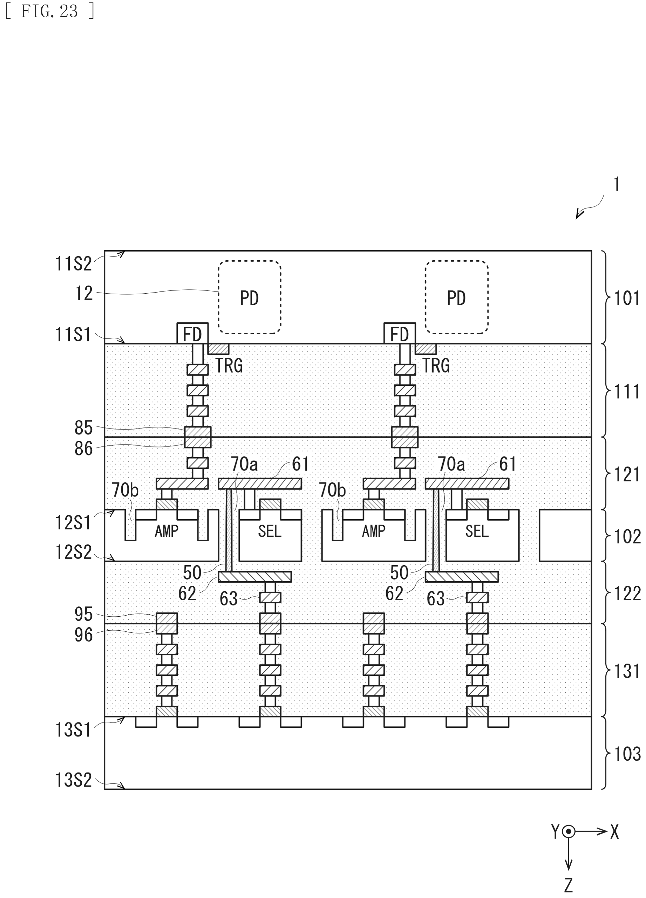

For example, as illustrated in FIG. 21, the insulating layer 70b may be provided to penetrate the second substrate 102. In other words, the insulating layer 70 may be formed to reach the surface 12S2 of the second substrate 102. In addition, as in an example illustrated in FIG. 23, the insulating layer 70 may be formed to between the surface 12S1 and the surface 12S2 of the second substrate 102. In the example illustrated in FIG. 23, the insulating layer 70 is provided from the side of the surface 12S1 of the second substrate 102 to between the surface 12S1 and the surface 12S2 of the second substrate 102. In a case of the present modification example also, it is possible to achieve effects similar to those of the imaging device according to the embodiments described above.

### (4-2. Modification Example 2)

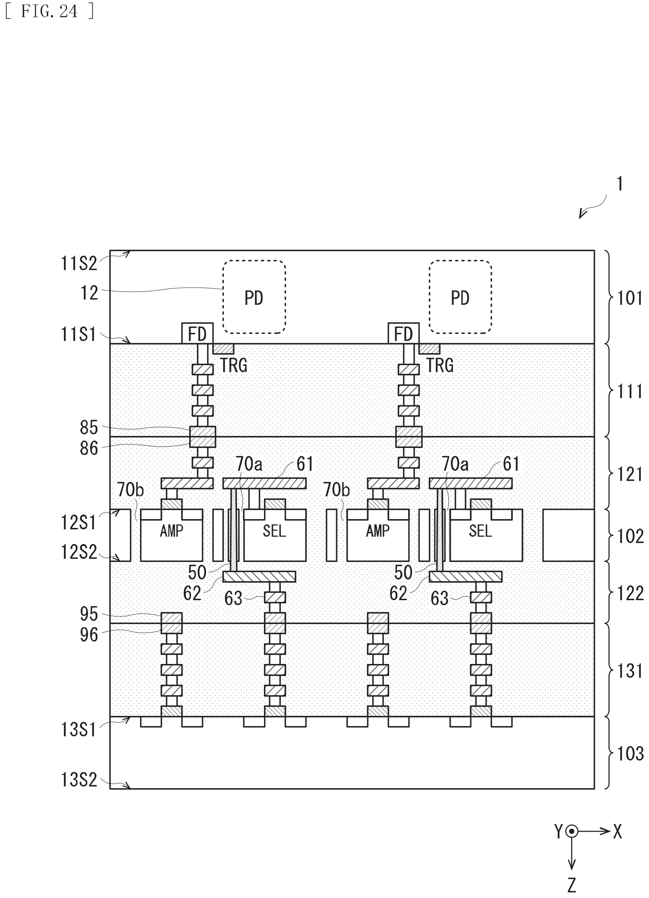

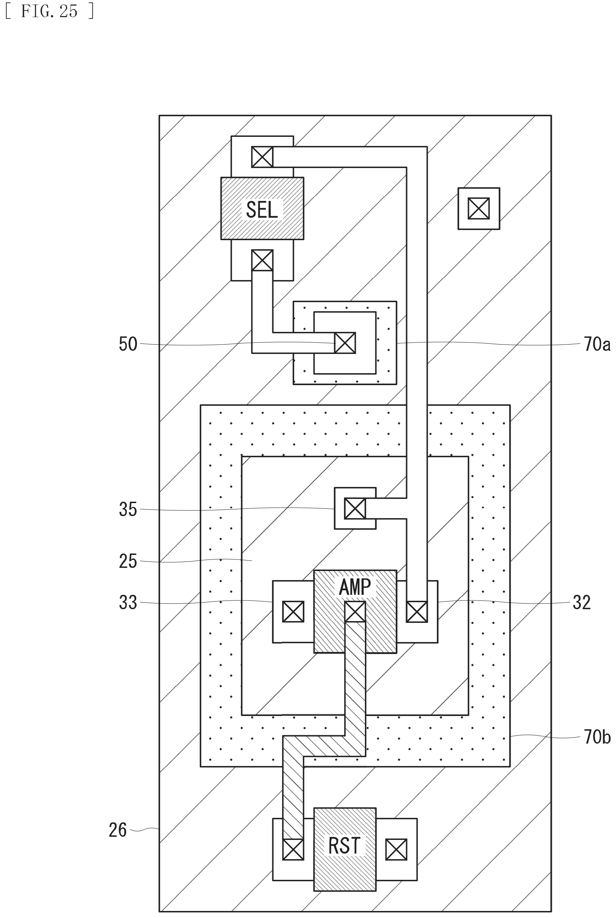

FIG. 24 is an explanatory diagram of an example of a cross-sectional configuration of an imaging device according to Modification Example 2. In addition, FIG. 25 is an explanatory diagram of an example of a planar configuration of the imaging device according to Modification Example 2. The insulating layer 70 (the insulating layer 70a in FIGs. 24 and 25) provided around the through electrode 50 may be provided around the through electrode 50 with a portion of the second substrate 102 interposed therebetween.

In the example illustrated in FIGs. 24 and 25, the through electrode 50 and the insulating layer 70a are disposed with a portion of the second substrate 102 interposed therebetween. The insulating layer 70a may be provided in contact with the through electrode 50 with the portion of the second substrate 102 interposed therebetween. In a case of the imaging device 1 according to the present modification example also, providing the insulating layer 70a makes it possible to reduce a parasitic capacitance to be added to the through electrode 50. It is possible to suppress a decrease in quality of a pixel signal.

### (4-3. Modification Example 3)

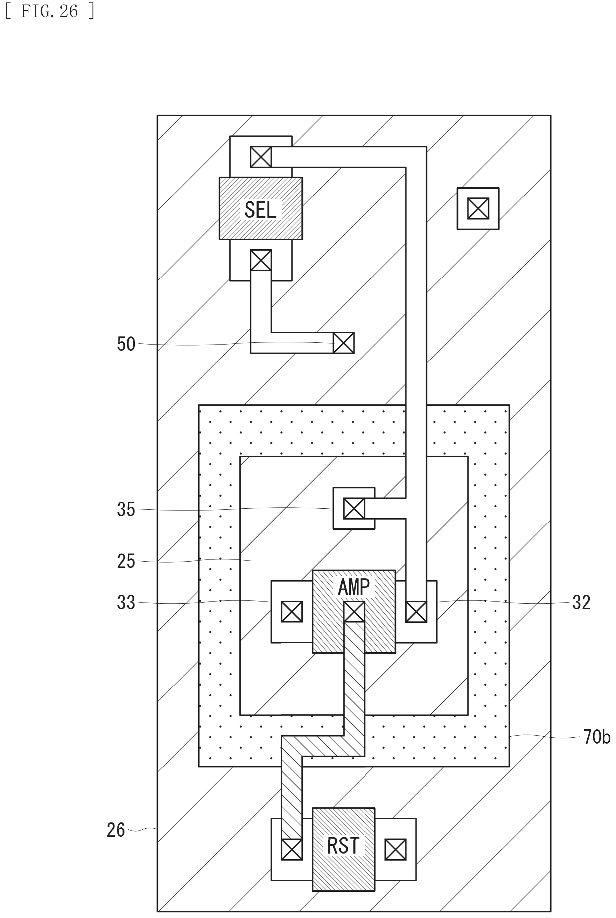

FIG. 26 is an explanatory diagram of a configuration example of an imaging device according to Modification Example 3. The imaging device 1 may have a configuration including only one of the insulating layer 70a that is provided around the through electrode 50 or the insulating layer 70b that is provided between wells. For example, as in the example illustrated in FIG. 26, only the insulating layer 70b may be provided without providing the insulating layer 70a. In addition, for example, only the insulating layer 70a may be provided without providing the insulating layer 70b.

### (4-4. Modification Example 4)

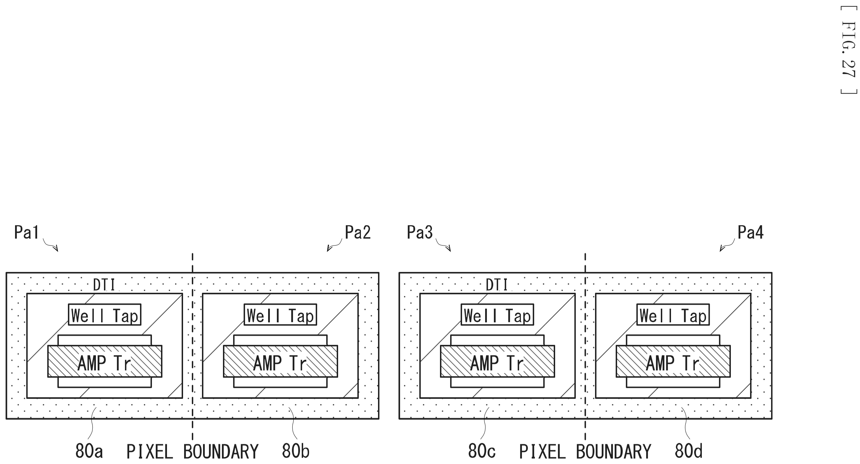

The description has been given, in the embodiments described above, of the configuration examples of the imaging device 1 including the separation region 80; however, the configuration examples are merely examples, and the configuration of the imaging device 1 is not limited to the examples described above. FIG. 27 is an explanatory diagram of a configuration example of an imaging device according to Modification Example 4. As in the example illustrated in FIG. 27, the imaging device 1 may include, for every two pixels P, the separation region 80 including a portion shared by the pixels P. The two pixels P are adjacent to each other in the horizontal direction (the row direction) or the vertical direction (the column direction).

In the example illustrated in FIG. 27, the separation region 80a and the separation region 80b provided for the pixel Pa1 and the pixel Pa2 adjacent to each other are configured to include a portion shared by the pixel Pa1 and the pixel Pa2. In addition, a separation region 80c and a separation region 80d provided for a pixel Pa3 and a pixel Pa4 adjacent to each other are configured to include a portion shared by the pixel Pa3 and the pixel Pa4.

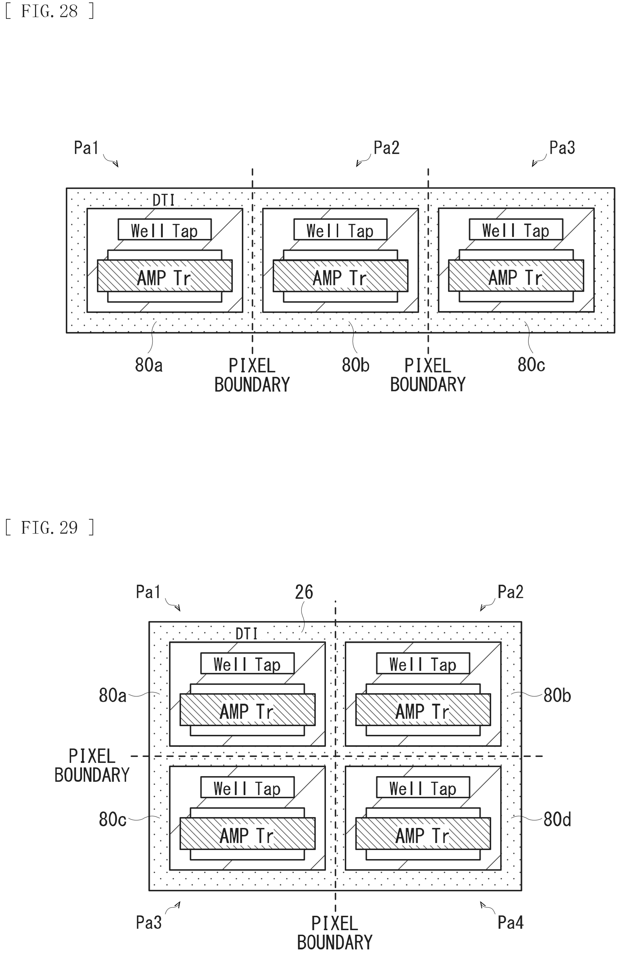

FIGs. 28 and 29 are each an explanatory diagram of another configuration example of the imaging device according to Modification Example 4. As in the example illustrated in FIG. 28, in the imaging device 1, the separation region 80 including a portion shared by the pixels P may be provided for every three pixels P. In the example illustrated in FIG. 28, the separation regions 80a to 80c provided for the pixels Pa1 to Pa3 adjacent to each other are configured to include a portion shared by the pixels Pa1 to Pa3.

In addition, in the imaging device 1, as in the example illustrated in FIG. 29, the separation region 80 including a portion shared by the pixels P may be provided for every four pixels P. In the example illustrated in FIG. 29, the separation regions 80a to 80d provided for the pixels Pa1 to Pa4 adjacent to each other are configured to include a portion shared by the pixels Pa1 to Pa4.

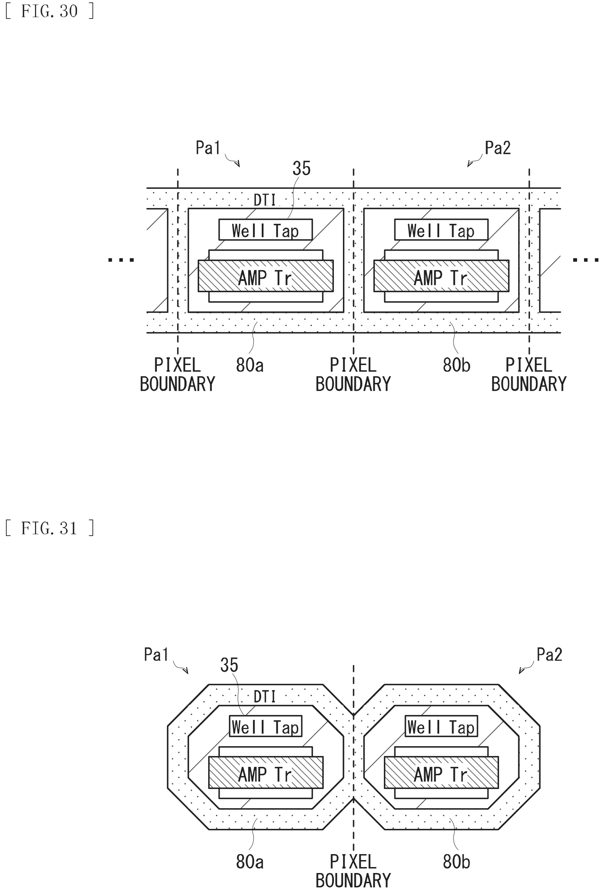

FIG. 30 is an explanatory diagram of another configuration example of the imaging device according to Modification Example 4. As in the example schematically illustrated in FIG. 30, the separation region 80 including a portion shared by a plurality of pixels P may be provided for each pixel row (or each pixel column) including a plurality of pixels P arranged in the horizontal direction (or the vertical direction).

### (4-5. Modification Example 5)

The shape of the separation region 80 of the imaging device 1 is not limited to the illustrated examples, and is appropriately modifiable. The shape of the separation region 80 in a plan view may be a quadrilateral shape, or may be circular shape or an elliptical shape. The shape of the separation region 80 may be a polygonal shape (e.g., a hexagonal shape or an octagonal shape), or another shape.

FIG. 31 is an explanatory diagram of a configuration example of an imaging device according to Modification example 5. The separation region 80 may have a shape having five or more straight lines in a plan view, as in the example illustrated in FIG. 31. The separation region 80 may have, for example, a polygonal shape with five or more sides. Configuring the separation region 80 as in the example illustrated in FIG. 31 makes it possible to prevent a residue from easily remaining due to an increased line width of a corner portion of the separation region 80.

### (4-6. Modification Example 6)

The imaging device 1 may have a configuration in which at least a portion of the separation region 80 is shared by a plurality of pixel units (pixel blocks) each including a plurality of pixels P. For example, a pixel unit including four pixels P may have one readout circuit 20 and the separation region 80 including a portion shared by a plurality of pixel units may be provided.

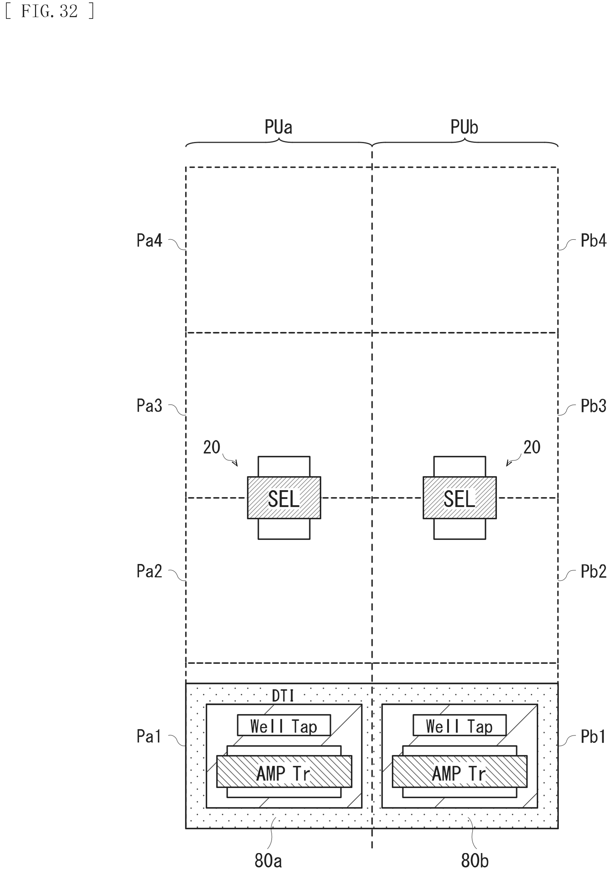

FIG. 32 is an explanatory diagram of a configuration example of an imaging device according to Modification example 6. FIG. 32 illustrates a pixel unit PUa including the pixels Pa1 to Pa4 adjacent to each other, and a pixel unit PUb including pixels Pb1 to Pb4 adjacent to each other. In the example illustrated in FIG. 32, the separation region 80a is provided to surround the amplification transistor AMP of the readout circuit 20 of the pixel unit PUa (that is, the readout circuit 20 shared by the pixels Pa1 to Pa4).

The separation region 80b s provided to surround the amplification transistor AMP of the readout circuit 20 of the pixel unit PUb (that is, the readout circuit 20 shared by the pixels Pb1 to Pb4). The separation region 80a and the separation region 80b may be configured to include a portion shared by the pixel unit PUa and the pixel unit PUb. In a case of the present modification example also, it is possible to achieve effects similar to those of the imaging device according to the embodiments described above.

### (4-7. Modification Example 7)

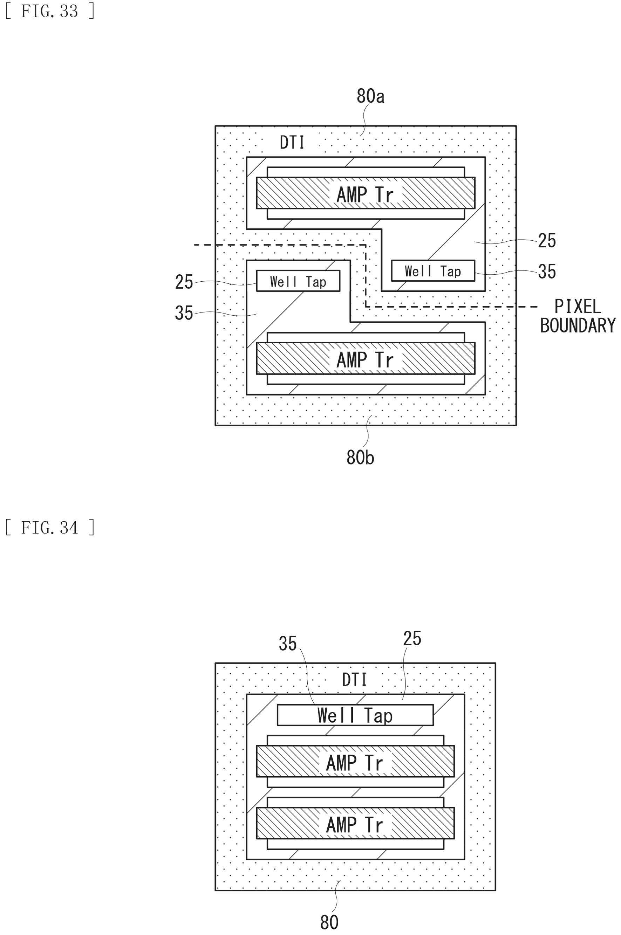

FIG. 33 is an explanatory diagram of a configuration example of an imaging device according to Modification example 7. As in the example illustrated in FIG. 33, the well 25 may be formed to have a shape including a recess (or a protrusion). In the imaging device 1, the separation region 80 including a portion shared by a plurality of pixels P (or a plurality of pixel units) adjacent to each other in a gate length direction of the amplification transistor AMP may be provided. Configuring the imaging device 1 as in the example illustrated in FIG. 33 makes it possible to improve area efficiency in the pixels P (or the pixel units).

### (4-8. Modification Example 8)

FIG. 34 is an explanatory diagram of a configuration example of an imaging device according to Modification example 8. The separation region 80 may be provided to surround a plurality of amplification transistors AMP (two amplification transistors AMP in FIG. 34). For example, in a case where the readout circuit 20 includes two amplification transistors AMP electrically coupled in parallel to each other, the separation region 80 may be disposed to surround the two amplification transistors AMP of the readout circuit 20.

### (4-9. Modification Example 9)

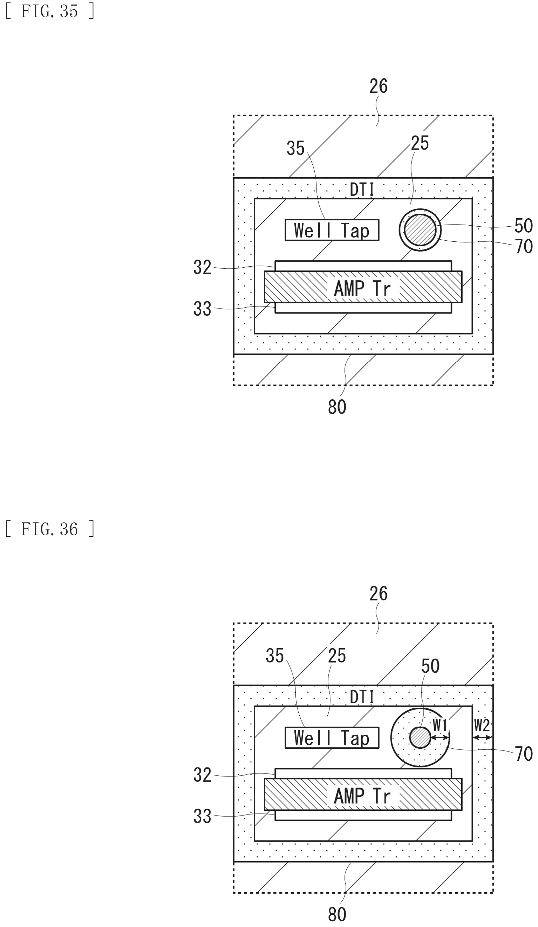

FIGs. 35 to 37 are each an explanatory diagram of a configuration example of an imaging device according to Modification example 9. In the imaging device 1, the through electrode 50 may be provided in the well 25. In the example illustrated in FIG. 35 or the like, the through electrode 50 is provided in a region of the well 25 surrounded by the separation region 80. In a case of the present modification example, it is possible to improve conversion efficiency.

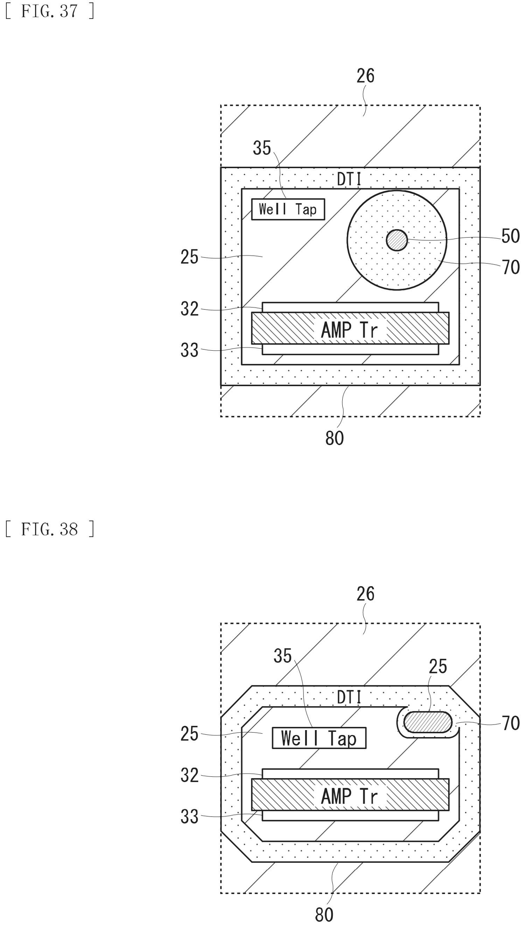

As in the example illustrated in FIG. 36, the width W1 of an insulating film provided around the through electrode 50, that is, the insulating layer 70 may be, for example, substantially equal to the width W2 of the separation region 80. The imaging device 1 may be configured to allow the width W1 of the insulating layer 70 (that is, the insulating film) to be, for example, equal to the width W2 of the separation region 80. It is to be noted that, as in the example illustrated in FIG. 37, the width W1 of the insulating layer 70 may be twice or more as large as the width W2 of the separation region 80.

The insulating layer 70 may be configured to have a dielectric constant lower than a dielectric constant of the material included in the separation region 80. The insulating layer 70 may be configured using, for example, a material having a dielectric constant lower than a dielectric constant of a material embedded in the trench of the separation region 80.

FIG. 38 is an explanatory diagram of another configuration example of the imaging device according to Modification example 9. As in the example illustrated in FIG. 38, the imaging device 1 may be configured to include a portion shared by the insulating layer 70 and the separation region 80. The insulating layer 70 may be configured using the same material (e.g., a silicon oxide film) as that of the separation region 80. Configuring the imaging device 1 as in the example illustrated in FIG. 38 makes it possible to improve area efficiency of the pixels P (or the pixel units).

### (4-10. Modification Example 10)

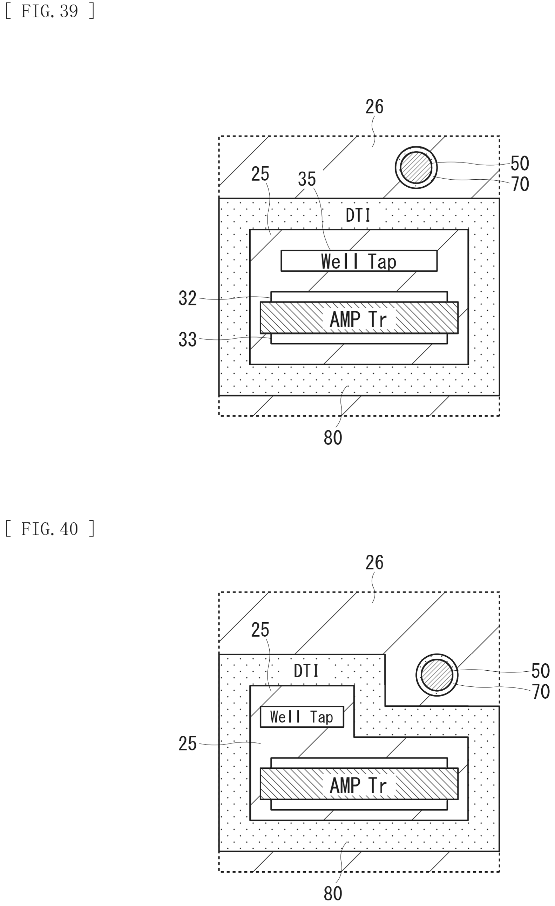

FIGs. 39 and 40 are each an explanatory diagram of a configuration example of an imaging device according to Modification example 10. As in the example illustrated in FIG. 39 or FIG. 40, the through electrode 50 may be provided in a region outside the well 25, e.g., in the well 26. This makes it possible to reduce noise mixed to the pixel signal, as compared with a case of FIG. 35, for example.

### (4-11. Modification Example 11)

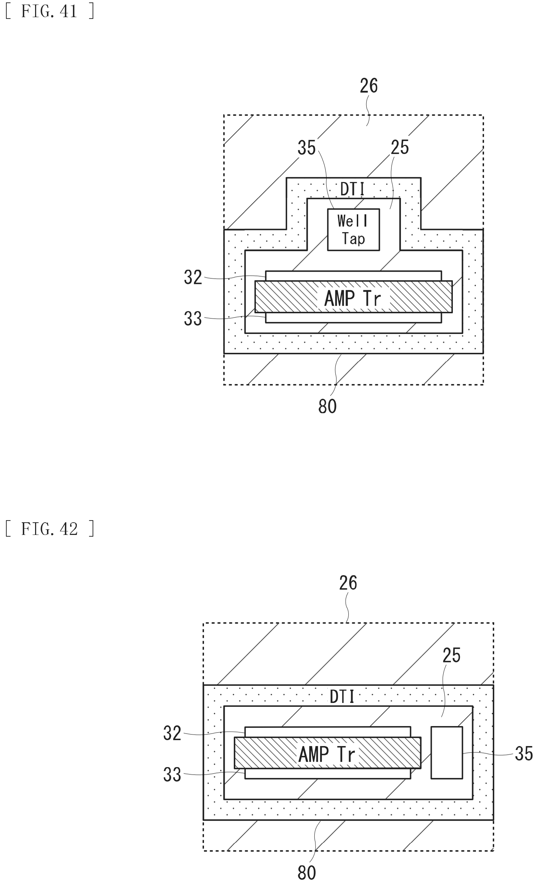

FIG. 41 is an explanatory diagram of a configuration example of an imaging device according to Modification example 11. The well 25 may have a protruding structure portion in a plan view. As in the example illustrated in FIG. 41, a middle region of the well 25 may be configured to include a protruding structure (a protrusion).

FIG. 42 is an explanatory diagram of another configuration example of the imaging device according to Modification example 11. The shape and position of the semiconductor region 35 as a well contact region is appropriately modifiable. For example, as in the example illustrated in FIG. 42, the semiconductor region 35 may be disposed adjacent to the amplification transistor AMP in the gate width direction of the amplification transistor AMP.

### <5. Application Example>

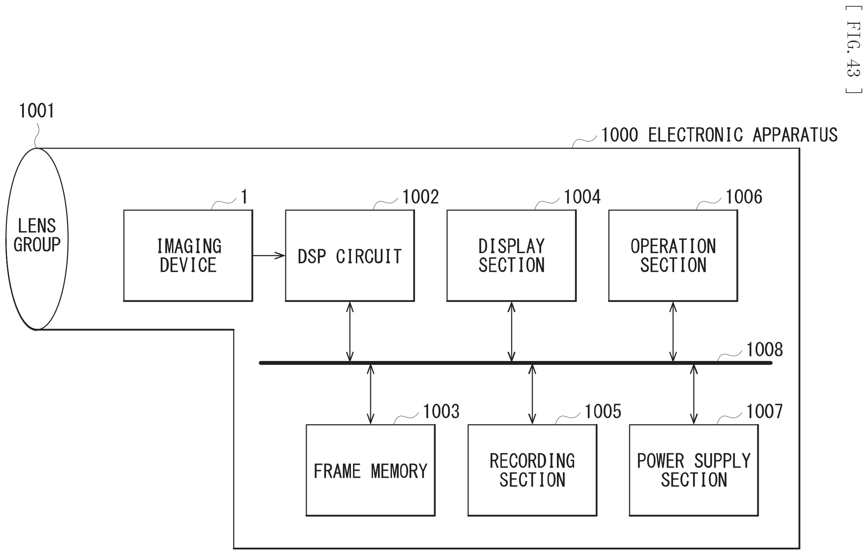

The imaging device 1 or the like described above is applicable, for example, to any type of electronic apparatus with an imaging function including a camera system such as a digital still camera or a video camera, a mobile phone having an imaging function, and the like. FIG. 43 illustrates a schematic configuration of an electronic apparatus 1000.

The electronic apparatus 1000 includes, for example, a lens group 1001, the imaging device 1, a DSP (Digital Signal Processor) circuit 1002, a frame memory 1003, a display section 1004, a recording section 1005, an operation section 1006, and a power supply section 1007, which are coupled to each other via a bus line 1008.

The lens group 1001 takes in incident light (image light) from a subject, and forms an image on an imaging surface of the imaging device 1. The imaging device 1 converts the amount of incident light formed as an image on the imaging surface by the lens group 1001 into electric signals on a pixel-by-pixel basis, and supplies the DSP circuit 1002 with the electric signals as pixel signals.

The DSP circuit 1002 is a signal processing circuit that processes signals supplied from the imaging device 1. The DSP circuit 1002 outputs image data obtained by processing the signals from the imaging device 1. The frame memory 1003 temporarily holds the image data processed by the DSP circuit 1002 on a frame-by-frame basis.

The display section 1004 includes, for example, a panel-type display device such as a liquid crystal panel or an organic EL (Electro Luminescence) panel, and records image data of a moving image or a still image captured by the imaging device 1 in a recording medium such as a semiconductor memory or a hard disk.

The operation section 1006 outputs an operation signal for a variety of functions of the electronic apparatus 1000 in accordance with an operation by a user. The power supply section 1007 appropriately supplies the DSP circuit 1002, the frame memory 1003, the display section 1004, the recording section 1005, and the operation section 1006 with various kinds of power for operations of these supply targets.

### <6. Practical Application Examples>

### (Example of Practical Application to Mobile Body)

The technology according to the present disclosure (the present technology) is applicable to a variety of products. For example, the technology according to the present disclosure may be achieved as a device mounted on any type of mobile body such as an automobile, an electric vehicle, a hybrid electric vehicle, a motorcycle, a bicycle, a personal mobility, an aircraft, a drone, a vessel, or a robot.

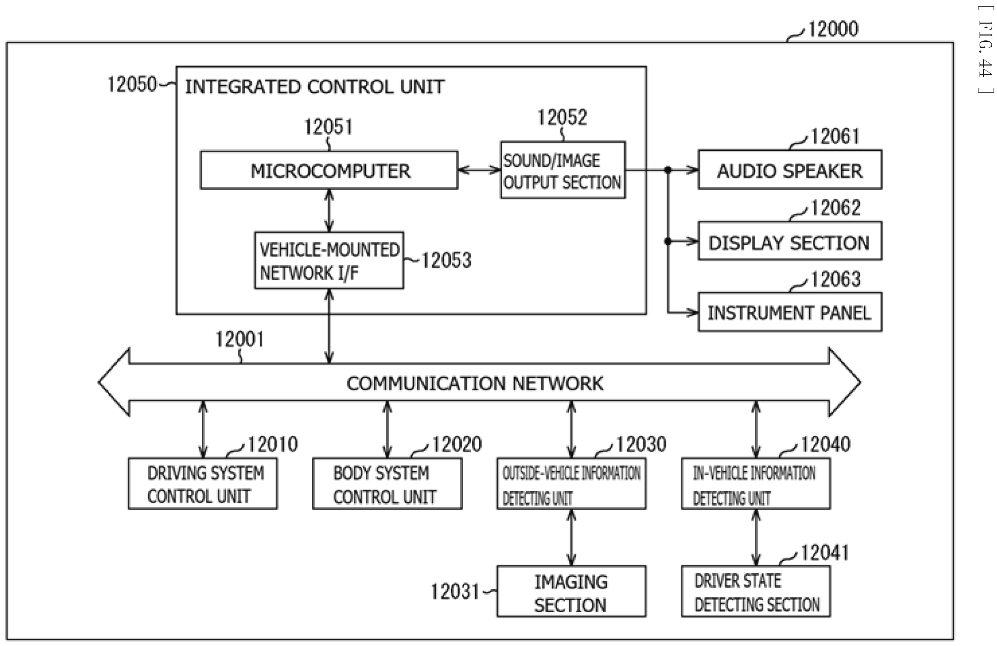

FIG. 44 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in FIG. 44, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 44, an audio speaker 12061, a display section 12062, and an instrument panel 12063 are illustrated as the output device. The display section 12062 may, for example, include at least one of an on-board display and a head-up display.

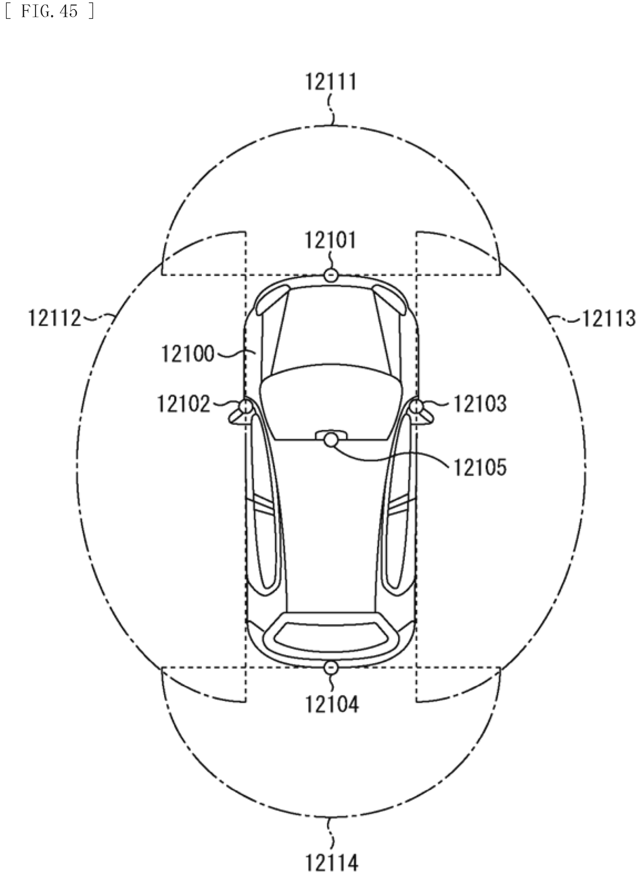

FIG. 45 is a diagram depicting an example of the installation position of the imaging section 12031.

In FIG. 45, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, FIG. 45 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

The description has been given hereinabove of one example of the mobile body control system to which the technology according to the present disclosure is applicable. The technology according to the present disclosure is applicable to the imaging section 12031, for example, of the configurations described above. Specifically, for example, the imaging device 1 or the like is applicable to the imaging section 12031. Applying the technology according to the present disclosure to the imaging section 12031 makes it possible to obtain a photographed image having high definition. It is possible to perform highly accurate control using the photographed image in the mobile body control system.

### (Example of Practical Application to Endoscopic Surgery System)

The technology according to the present disclosure (the present technology) is applicable to various products. For example, the technology according to the present disclosure may be applied to an endoscopic surgery system.

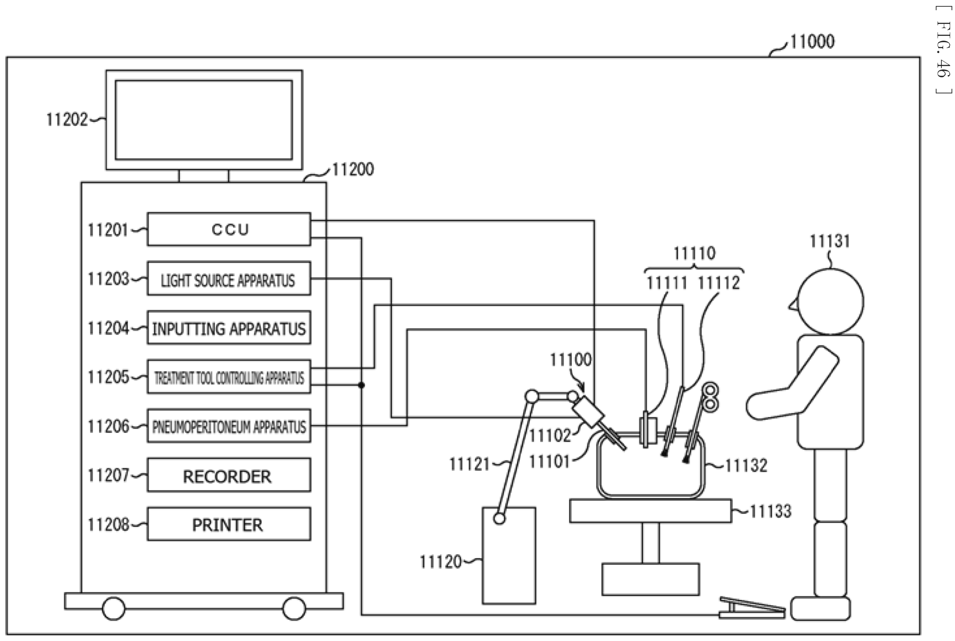

FIG. 46 is a view depicting an example of a schematic configuration of an endoscopic surgery system to which the technology according to an embodiment of the present disclosure (present technology) can be applied.

In FIG. 46, a state is illustrated in which a surgeon (medical doctor) 11131 is using an endoscopic surgery system 11000 to perform surgery for a patient 11132 on a patient bed 11133. As depicted, the endoscopic surgery system 11000 includes an endoscope 11100, other surgical tools 11110 such as a pneumoperitoneum tube 11111 and an energy device 11112, a supporting arm apparatus 11120 which supports the endoscope 11100 thereon, and a cart 11200 on which various apparatus for endoscopic surgery are mounted.

The endoscope 11100 includes a lens barrel 11101 having a region of a predetermined length from a distal end thereof to be inserted into a body cavity of the patient 11132, and a camera head 11102 connected to a proximal end of the lens barrel 11101. In the example depicted, the endoscope 11100 is depicted which includes as a rigid endoscope having the lens barrel 11101 of the hard type. However, the endoscope 11100 may otherwise be included as a flexible endoscope having the lens barrel 11101 of the flexible type.

The lens barrel 11101 has, at a distal end thereof, an opening in which an objective lens is fitted. A light source apparatus 11203 is connected to the endoscope 11100 such that light generated by the light source apparatus 11203 is introduced to a distal end of the lens barrel 11101 by a light guide extending in the inside of the lens barrel 11101 and is irradiated toward an observation target in a body cavity of the patient 11132 through the objective lens. It is to be noted that the endoscope 11100 may be a forward-viewing endoscope or may be an oblique-viewing endoscope or a side-viewing endoscope.

An optical system and an image pickup element are provided in the inside of the camera head 11102 such that reflected light (observation light) from the observation target is condensed on the image pickup element by the optical system. The observation light is photo-electrically converted by the image pickup element to generate an electric signal corresponding to the observation light, namely, an image signal corresponding to an observation image. The image signal is transmitted as RAW data to a CCU 11201.

The CCU 11201 includes a central processing unit (CPU), a graphics processing unit (GPU) or the like and integrally controls operation of the endoscope 11100 and a display apparatus 11202. Further, the CCU 11201 receives an image signal from the camera head 11102 and performs, for the image signal, various image processes for displaying an image based on the image signal such as, for example, a development process (demosaic process).

The display apparatus 11202 displays thereon an image based on an image signal, for which the image processes have been performed by the CCU 11201, under the control of the CCU 11201.

The light source apparatus 11203 includes a light source such as, for example, a light emitting diode (LED) and supplies irradiation light upon imaging of a surgical region to the endoscope 11100.

An inputting apparatus 11204 is an input interface for the endoscopic surgery system 11000. A user can perform inputting of various kinds of information or instruction inputting to the endoscopic surgery system 11000 through the inputting apparatus 11204. For example, the user would input an instruction or a like to change an image pickup condition (type of irradiation light, magnification, focal distance or the like) by the endoscope 11100.

A treatment tool controlling apparatus 11205 controls driving of the energy device 11112 for cautery or incision of a tissue, sealing of a blood vessel or the like. A pneumoperitoneum apparatus 11206 feeds gas into a body cavity of the patient 11132 through the pneumoperitoneum tube 11111 to inflate the body cavity in order to secure the field of view of the endoscope 11100 and secure the working space for the surgeon. A recorder 11207 is an apparatus capable of recording various kinds of information relating to surgery. A printer 11208 is an apparatus capable of printing various kinds of information relating to surgery in various forms such as a text, an image or a graph.

It is to be noted that the light source apparatus 11203 which supplies irradiation light when a surgical region is to be imaged to the endoscope 11100 may include a white light source which includes, for example, an LED, a laser light source or a combination of them. Where a white light source includes a combination of red, green, and blue (RGB) laser light sources, since the output intensity and the output timing can be controlled with a high degree of accuracy for each color (each wavelength), adjustment of the white balance of a picked up image can be performed by the light source apparatus 11203. Further, in this case, if laser beams from the respective RGB laser light sources are irradiated time-divisionally on an observation target and driving of the image pickup elements of the camera head 11102 are controlled in synchronism with the irradiation timings. Then images individually corresponding to the R, G and B colors can be also picked up time-divisionally. According to this method, a color image can be obtained even if color filters are not provided for the image pickup element.

Further, the light source apparatus 11203 may be controlled such that the intensity of light to be outputted is changed for each predetermined time. By controlling driving of the image pickup element of the camera head 11102 in synchronism with the timing of the change of the intensity of light to acquire images time-divisionally and synthesizing the images, an image of a high dynamic range free from underexposed blocked up shadows and overexposed highlights can be created.

Further, the light source apparatus 11203 may be configured to supply light of a predetermined wavelength band ready for special light observation. In special light observation, for example, by utilizing the wavelength dependency of absorption of light in a body tissue to irradiate light of a narrow band in comparison with irradiation light upon ordinary observation (namely, white light), narrow band observation (narrow band imaging) of imaging a predetermined tissue such as a blood vessel of a superficial portion of the mucous membrane or the like in a high contrast is performed. Alternatively, in special light observation, fluorescent observation for obtaining an image from fluorescent light generated by irradiation of excitation light may be performed. In fluorescent observation, it is possible to perform observation of fluorescent light from a body tissue by irradiating excitation light on the body tissue (auto fluorescence observation) or to obtain a fluorescent light image by locally injecting a reagent such as indocyanine green (ICG) into a body tissue and irradiating excitation light corresponding to a fluorescent light wavelength of the reagent upon the body tissue. The light source apparatus 11203 can be configured to supply such narrow-band light and/or excitation light suitable for special light observation as described above.

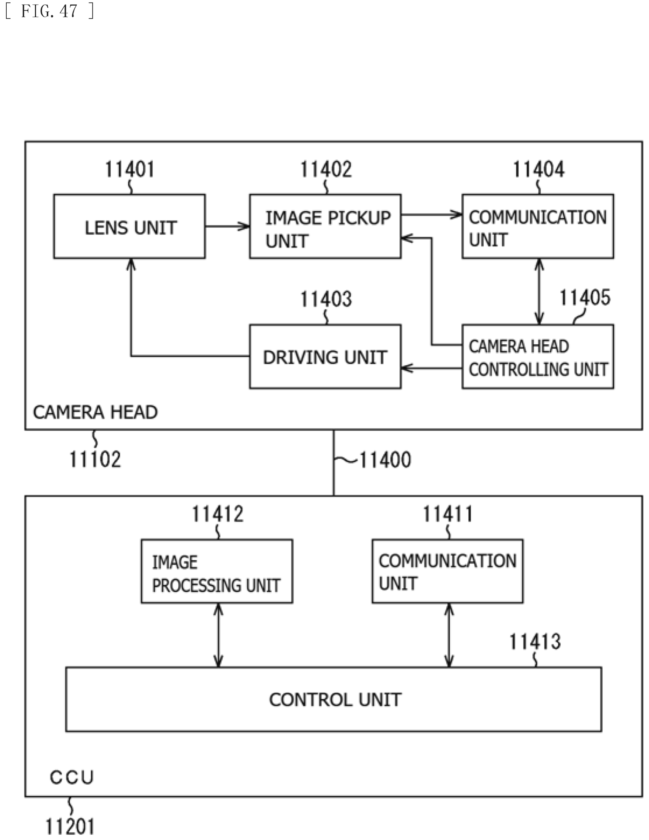

FIG. 47 is a block diagram depicting an example of a functional configuration of the camera head 11102 and the CCU 11201 depicted in FIG. 46.

The camera head 11102 includes a lens unit 11401, an image pickup unit 11402, a driving unit 11403, a communication unit 11404 and a camera head controlling unit 11405. The CCU 11201 includes a communication unit 11411, an image processing unit 11412 and a control unit 11413. The camera head 11102 and the CCU 11201 are connected for communication to each other by a transmission cable 11400.

The lens unit 11401 is an optical system, provided at a connecting location to the lens barrel 11101. Observation light taken in from a distal end of the lens barrel 11101 is guided to the camera head 11102 and introduced into the lens unit 11401. The lens unit 11401 includes a combination of a plurality of lenses including a zoom lens and a focusing lens.

The number of image pickup elements which is included by the image pickup unit 11402 may be one (single-plate type) or a plural number (multi-plate type). Where the image pickup unit 11402 is configured as that of the multi-plate type, for example, image signals corresponding to respective R, G and B are generated by the image pickup elements, and the image signals may be synthesized to obtain a color image. The image pickup unit 11402 may also be configured so as to have a pair of image pickup elements for acquiring respective image signals for the right eye and the left eye ready for three dimensional (3D) display. If 3D display is performed, then the depth of a living body tissue in a surgical region can be comprehended more accurately by the surgeon 11131. It is to be noted that, where the image pickup unit 11402 is configured as that of stereoscopic type, a plurality of systems of lens units 11401 are provided corresponding to the individual image pickup elements.

Further, the image pickup unit 11402 may not necessarily be provided on the camera head 11102. For example, the image pickup unit 11402 may be provided immediately behind the objective lens in the inside of the lens barrel 11101.

The driving unit 11403 includes an actuator and moves the zoom lens and the focusing lens of the lens unit 11401 by a predetermined distance along an optical axis under the control of the camera head controlling unit 11405. Consequently, the magnification and the focal point of a picked up image by the image pickup unit 11402 can be adjusted suitably.

The communication unit 11404 includes a communication apparatus for transmitting and receiving various kinds of information to and from the CCU 11201. The communication unit 11404 transmits an image signal acquired from the image pickup unit 11402 as RAW data to the CCU 11201 through the transmission cable 11400.

In addition, the communication unit 11404 receives a control signal for controlling driving of the camera head 11102 from the CCU 11201 and supplies the control signal to the camera head controlling unit 11405. The control signal includes information relating to image pickup conditions such as, for example, information that a frame rate of a picked up image is designated, information that an exposure value upon image picking up is designated and/or information that a magnification and a focal point of a picked up image are designated.

It is to be noted that the image pickup conditions such as the frame rate, exposure value, magnification or focal point may be designated by the user or may be set automatically by the control unit 11413 of the CCU 11201 on the basis of an acquired image signal. In the latter case, an auto exposure (AE) function, an auto focus (AF) function and an auto white balance (AWB) function are incorporated in the endoscope 11100.

The camera head controlling unit 11405 controls driving of the camera head 11102 on the basis of a control signal from the CCU 11201 received through the communication unit 11404.

The communication unit 11411 includes a communication apparatus for transmitting and receiving various kinds of information to and from the camera head 11102. The communication unit 11411 receives an image signal transmitted thereto from the camera head 11102 through the transmission cable 11400.

Further, the communication unit 11411 transmits a control signal for controlling driving of the camera head 11102 to the camera head 11102. The image signal and the control signal can be transmitted by electrical communication, optical communication or the like.

The image processing unit 11412 performs various image processes for an image signal in the form of RAW data transmitted thereto from the camera head 11102.

The control unit 11413 performs various kinds of control relating to image picking up of a surgical region or the like by the endoscope 11100 and display of a picked up image obtained by image picking up of the surgical region or the like. For example, the control unit 11413 creates a control signal for controlling driving of the camera head 11102.

Further, the control unit 11413 controls, on the basis of an image signal for which image processes have been performed by the image processing unit 11412, the display apparatus 11202 to display a picked up image in which the surgical region or the like is imaged. Thereupon, the control unit 11413 may recognize various objects in the picked up image using various image recognition technologies. For example, the control unit 11413 can recognize a surgical tool such as forceps, a particular living body region, bleeding, mist when the energy device 11112 is used and so forth by detecting the shape, color and so forth of edges of objects included in a picked up image. The control unit 11413 may cause, when it controls the display apparatus 11202 to display a picked up image, various kinds of surgery supporting information to be displayed in an overlapping manner with an image of the surgical region using a result of the recognition. Where surgery supporting information is displayed in an overlapping manner and presented to the surgeon 11131, the burden on the surgeon 11131 can be reduced and the surgeon 11131 can proceed with the surgery with certainty.

The transmission cable 11400 which connects the camera head 11102 and the CCU 11201 to each other is an electric signal cable ready for communication of an electric signal, an optical fiber ready for optical communication or a composite cable ready for both of electrical and optical communications.

Here, while, in the example depicted, communication is performed by wired communication using the transmission cable 11400, the communication between the camera head 11102 and the CCU 11201 may be performed by wireless communication.

The description has been given hereinabove of one example of the endoscopic surgery system to which the technology according to the present disclosure is applicable. The technology according to the present disclosure is suitably applicable to, for example, the image pickup unit 11402 provided in the camera head 11102 of the endoscope 11100 of the configurations described above. Applying the technology according to the present disclosure to the image pickup unit 11402 makes it possible to provide the endoscope 11100 having high definition.

Although the present disclosure has been described above with reference to the embodiments, the modification examples, the application example, and the practical application examples, the present technology is not limited to the embodiments and the like described above, and may be modified in a variety of ways. For example, although the modification examples described above have been described as modification examples of the embodiments described above, the configurations of the respective modification examples may be combined as appropriate. For example, the present disclosure is not limited to back-illuminated image sensors, but is also applicable to front-illuminated image sensors.

In the embodiments described above and the like, the imaging device has been described as an example. However, it is sufficient for the light detecting device of the present disclosure, for example, to receive incident light and convert the light into electric charge. A signal to be outputted may be a signal of image information or a signal of distance measurement information. The light detecting device (the imaging device) is applicable to an image sensor, a distance measuring sensor, or the like.

The light detecting device according to the present disclosure is applicable as a distance measuring sensor that is able to perform distance measurement of a TOF (Time Of Flight) method. The light detecting device (the imaging device) is also applicable as a sensor that is able to detect an event, e.g., an event-driven type sensor (referred to as an EVS (Event Vision Sensor), an EDS (Event Driven Sensor), a DVS (Dynamic Vision Sensor), etc.).

A light detecting device according to an embodiment of the present disclosure includes: a first substrate including a plurality of photoelectric conversion elements; a second substrate stacked on the first substrate, and including a plurality of readout circuits that is each configured to output a first signal based on electric charge converted by the photoelectric conversion element; a through electrode provided for each readout circuit or every plurality of readout circuits in the second substrate, and configured to transmit the first signal; and a first insulating layer provided to penetrate the second substrate around the through electrode. This makes it possible to achieve a light detecting device that makes it possible to suppress a decrease in signal quality.

A light detecting device according to an embodiment of the present disclosure includes: a first substrate including a plurality of photoelectric conversion elements; a second substrate including a plurality of readout circuits, and stacked on the first substrate, the plurality of readout circuits each including an amplification transistor that is configured to generate a first signal based on electric charge converted by the photoelectric conversion element; a through electrode provided for each readout circuit or every plurality of readout circuits in the second substrate, and configured to transmit the first signal; and an insulating layer provided to surround the amplification transistor in the second substrate. This makes it possible to achieve a light detecting device that makes it possible to suppress a decrease in signal quality.

It is to be noted that the effects described herein are merely exemplary and are not limited to the description, and may further include other effects. In addition, the present disclosure may also have the following configurations.
(1) A light detecting device including:
   a first substrate including a plurality of photoelectric conversion elements that each photoelectrically converts light;
   a second substrate stacked on the first substrate, and including a plurality of readout circuits that is each configured to output a first signal based on electric charge converted by the photoelectric conversion element;
   a through electrode provided for each of the readout circuits or every plurality of the readout circuits in the second substrate, and configured to transmit the first signal; and
   a first insulating layer provided to penetrate the second substrate around the through electrode.
(2) The light detecting device according to (1), in which the first substrate and the second substrate are stacked to cause a first surface, on which an element is formed, of the first substrate and a second surface, on which an element is formed, of the second substrate to be opposed each other.
(3) The light detecting device according to (2), further including a wiring layer provided on a side of a third surface opposite to the second surface of the second substrate, in which
   the wiring layer includes a wiring that is electrically coupled to the through electrode that penetrates the second substrate.
(4) The light detecting device according to (2) or (3), further including a third substrate including a signal processing section that is configured to perform signal processing.
(5) The light detecting device according to (4), in which the second substrate and the third substrate are stacked to cause a third surface opposite to the second surface of the second substrate and a fourth surface, on which an element is formed, of the third substrate to be opposed to each other.
(6) The light detecting device according to (4) or (5), in which the second substrate and the third substrate are stacked by bonding between electrodes coupled to the through electrode.
(7) The light detecting device according to any one of (1) to (6), in which
   the readout circuit includes a selection transistor that is configured to output the first signal, and
   the through electrode is electrically coupled to the selection transistor.
(8) The light detecting device according to (7), in which the first insulating layer is provided between the selection transistor and the through electrode.
(9) The light detecting device according to any one of (1) to (8), in which
   the readout circuit includes an amplification transistor that is configured to generate the first signal, and
   the first insulating layer is provided to surround the amplification transistor in the second substrate.
(10) The light detecting device according to (9), in which a backgate of the amplification transistor is electrically coupled to a source of the amplification transistor.
(11) The light detecting device according to (9) or (10), further including:
   a first well of a first electrically conductive type provided in the second substrate; and
   a first semiconductor region of the first electrically conductive type provided in the first well, in which
   the amplification transistor includes a source region of a second electrically conductive type provided in the first well, and
   the first semiconductor region is electrically coupled to the source region.
(12) The light detecting device according to (11), in which the first insulating layer is provided to surround the first well in the second substrate.
(13) The light detecting device according to (11) or (12), further including a second well of the first electrically conductive type provided in the second substrate, in which
   the readout circuit includes a selection transistor that is configured to output the first signal, and
   a source region and a drain region of the selection transistor are provided in the second well.
(14) The light detecting device according to any one of (1) to (13), further including a second insulating layer different from the first insulating layer, in which
   the readout circuit includes an amplification transistor that is configured to generate the first signal, and
   the second insulating layer is provided to surround the amplification transistor in the second substrate.
(15) The light detecting device according to (14), in which the first insulating layer is provided outside the second insulating layer.
(16) The light detecting device according to (14) or (15), in which the second insulating layer is provided to penetrate the second substrate around the amplification transistor.
(17) A light detecting device including:
   a first substrate including a plurality of photoelectric conversion elements that each photoelectrically converts light;
   a second substrate including a plurality of readout circuits, and stacked on the first substrate, the plurality of readout circuits each including an amplification transistor that is configured to generate a first signal based on electric charge converted by the photoelectric conversion element;
   a through electrode provided for each of the readout circuits or every plurality of the readout circuits in the second substrate, and configured to transmit the first signal; and
   an insulating layer provided to surround the amplification transistor in the second substrate.
(18) The light detecting device according to (17), further including:
   a first well of a first electrically conductive type provided in the second substrate; and
   a first semiconductor region of the first electrically conductive type provided in the first well, in which
   the amplification transistor includes a source region of a second electrically conductive type provided in the first well, and
   the first semiconductor region is electrically coupled to the source region.
(19) A light detecting device including:
   a first substrate including a plurality of photoelectric conversion elements that each photoelectrically converts light;
   a second substrate stacked on the first substrate, and including a plurality of amplification transistors that is each configured to generate a first signal based on electric charge converted by the photoelectric conversion element;
   a first pixel and a second pixel each including the photoelectric conversion element and the amplification transistor;
   a first separation region provided to surround the amplification transistor of the first pixel in the second substrate; and
   a second separation region including at least a portion of the first separation region, and provided to surround the amplification transistor of the second pixel in the second substrate.
(20) The light detecting device according to (19), in which the first separation region and the second separation region each have a trench provided to surround the amplification transistor in the second substrate.
(21) The light detecting device according to (19) or (20), in which the first separation region and the second separation region are integrally provided.
(22) The light detecting device according to any one of (19) to (21), in which the first separation region and the second separation region are provided continuously at a boundary between the first pixel and the second pixel.
(23) The light detecting device according to any one of (19) to (22), further including:
   a first well of a first electrically conductive type surrounded by the first separation region in the second substrate; and
   a first semiconductor region of the first electrically conductive type provided in the first well, in which
   the amplification transistor includes a source region of a second electrically conductive type provided in the first well, and
   the first semiconductor region is electrically coupled to the source region.
(24) The light detecting device according to any one of (19) to (23), including a readout circuit including the amplification transistor and a selection transistor, and provided in the second substrate, the selection transistor configured to output the first signal, in which
   the selection transistor is provided outside the first separation region that is provided to surround the amplification transistor.
(25) The light detecting device according to any one of (19) to (24), in which the first separation region and the second separation region are each configured using silicon oxide, and each have a quadrilateral shape.
(26) The light detecting device according to any one of (19) to (25), in which the first separation region and the second separation region are each configured using polysilicon or silicon nitride.
(27) The light detecting device according to any one of (19) to (26), in which the first separation region and the second separation region each have a shape having five or more straight lines, a circular shape, or an elliptical shape.
(28) The light detecting device according to any one of (19) to (27), further including a third substrate including a signal processing section that is configured to perform signal processing.
(29) An electronic apparatus including:
   an optical system; and
   a light detecting device that receives light having passed through the optical system, in which
   the light detecting device includes
   a first substrate including a plurality of photoelectric conversion elements that each photoelectrically converts light,
   a second substrate stacked on the first substrate, and including a plurality of readout circuits that is each configured to output a first signal based on electric charge converted by the photoelectric conversion element,
   a through electrode provided for each of the readout circuits or every plurality of the readout circuits in the second substrate, and configured to transmit the first signal, and
   a first insulating layer provided to penetrate the second substrate around the through electrode.
(30) An electronic apparatus including:
   an optical system; and
   a light detecting device that receives light having passed through the optical system, in which
   the light detecting device includes
   a first substrate including a plurality of photoelectric conversion elements that each photoelectrically converts light,
   a second substrate including a plurality of readout circuits, and stacked on the first substrate, the plurality of readout circuits each including an amplification transistor that is configured to generate a first signal based on electric charge converted by the photoelectric conversion element,
   a through electrode provided for each of the readout circuits or every plurality of the readout circuits in the second substrate, and configured to transmit the first signal, and
   an insulating layer provided to surround the amplification transistor in the second substrate.
(31) An electronic apparatus including:
   an optical system; and
   a light detecting device that receives light having passed through the optical system, in which
   the light detecting device includes
   a first substrate including a plurality of photoelectric conversion elements that each photoelectrically converts light,
   a second substrate stacked on the first substrate, and including a plurality of amplification transistors that is each configured to generate a first signal based on electric charge converted by the photoelectric conversion element,
   a first pixel and a second pixel each including the photoelectric conversion element and the amplification transistor,
   a first separation region provided to surround the amplification transistor of the first pixel in the second substrate, and
   a second separation region including at least a portion of the first separation region, and provided to surround the amplification transistor of the second pixel in the second substrate.

The present application claims the benefit of Japanese Priority Patent Application JP2023-095803 filed with the Japan Patent Office on June 9, 2023, the entire contents of which are incorporated herein by reference.

It should be understood by those skilled in the art that various modifications, combinations, subcombinations, and alterations may occur depending on design requirements and other factors insofar as they are within the scope of the appended claims or the equivalents thereof.

## Claims

1. A light detecting device comprising:
a first substrate including a plurality of photoelectric conversion elements that each photoelectrically converts light;
a second substrate stacked on the first substrate, and including a plurality of readout circuits that is each configured to output a first signal based on electric charge converted by the photoelectric conversion element;
a through electrode provided for each of the readout circuits or every plurality of the readout circuits in the second substrate, and configured to transmit the first signal; and
a first insulating layer provided to penetrate the second substrate around the through electrode.

2. The light detecting device according to claim 1, wherein the first substrate and the second substrate are stacked to cause a first surface, on which an element is formed, of the first substrate and a second surface, on which an element is formed, of the second substrate to be opposed each other.

3. The light detecting device according to claim 2, further comprising a wiring layer provided on a side of a third surface opposite to the second surface of the second substrate, wherein
the wiring layer includes a wiring that is electrically coupled to the through electrode that penetrates the second substrate.

4. The light detecting device according to claim 2, further comprising a third substrate including a signal processing section that is configured to perform signal processing.

5. The light detecting device according to claim 4, wherein the second substrate and the third substrate are stacked to cause a third surface opposite to the second surface of the second substrate and a fourth surface, on which an element is formed, of the third substrate to be opposed to each other.

6. The light detecting device according to claim 4, wherein the second substrate and the third substrate are stacked by bonding between electrodes coupled to the through electrode.

7. The light detecting device according to claim 1, wherein
the readout circuit includes a selection transistor that is configured to output the first signal, and
the through electrode is electrically coupled to the selection transistor.

8. The light detecting device according to claim 7, wherein the first insulating layer is provided between the selection transistor and the through electrode.

9. The light detecting device according to claim 1, wherein
the readout circuit includes an amplification transistor that is configured to generate the first signal, and
the first insulating layer is provided to surround the amplification transistor in the second substrate.

10. The light detecting device according to claim 9, wherein a backgate of the amplification transistor is electrically coupled to a source of the amplification transistor.

11. The light detecting device according to claim 9, further comprising:
a first well of a first electrically conductive type provided in the second substrate; and
a first semiconductor region of the first electrically conductive type provided in the first well, wherein
the amplification transistor includes a source region of a second electrically conductive type provided in the first well, and
the first semiconductor region is electrically coupled to the source region.

12. The light detecting device according to claim 11, wherein the first insulating layer is provided to surround the first well in the second substrate.

13. The light detecting device according to claim 11, further comprising a second well of the first electrically conductive type provided in the second substrate, wherein
the readout circuit includes a selection transistor that is configured to output the first signal, and
a source region and a drain region of the selection transistor are provided in the second well.

14. The light detecting device according to claim 1, further comprising a second insulating layer different from the first insulating layer, wherein
the readout circuit includes an amplification transistor that is configured to generate the first signal, and
the second insulating layer is provided to surround the amplification transistor in the second substrate.

15. The light detecting device according to claim 14, wherein the first insulating layer is provided outside the second insulating layer.

16. The light detecting device according to claim 14, wherein the second insulating layer is provided to penetrate the second substrate around the amplification transistor.

17. A light detecting device comprising:
a first substrate including a plurality of photoelectric conversion elements that each photoelectrically converts light;
a second substrate including a plurality of readout circuits, and stacked on the first substrate, the plurality of readout circuits each including an amplification transistor that is configured to generate a first signal based on electric charge converted by the photoelectric conversion element;
a through electrode provided for each of the readout circuits or every plurality of the readout circuits in the second substrate, and configured to transmit the first signal; and
an insulating layer provided to surround the amplification transistor in the second substrate.

18. The light detecting device according to claim 17, further comprising:
a first well of a first electrically conductive type provided in the second substrate; and
a first semiconductor region of the first electrically conductive type provided in the first well, wherein
the amplification transistor includes a source region of a second electrically conductive type provided in the first well, and
the first semiconductor region is electrically coupled to the source region.

19. A light detecting device comprising:
a first substrate including a plurality of photoelectric conversion elements that each photoelectrically converts light;
a second substrate stacked on the first substrate, and including a plurality of amplification transistors that is each configured to generate a first signal based on electric charge converted by the photoelectric conversion element;
a first pixel and a second pixel each including the photoelectric conversion element and the amplification transistor;
a first separation region provided to surround the amplification transistor of the first pixel in the second substrate; and
a second separation region including at least a portion of the first separation region, and provided to surround the amplification transistor of the second pixel in the second substrate.

20. The light detecting device according to claim 19, wherein the first separation region and the second separation region each have a trench provided to surround the amplification transistor in the second substrate.

21. The light detecting device according to claim 19, wherein the first separation region and the second separation region are integrally provided.

22. The light detecting device according to claim 19, wherein the first separation region and the second separation region are provided continuously at a boundary between the first pixel and the second pixel.

23. The light detecting device according to claim 19, further comprising:
a first well of a first electrically conductive type surrounded by the first separation region in the second substrate; and
a first semiconductor region of the first electrically conductive type provided in the first well, wherein
the amplification transistor includes a source region of a second electrically conductive type provided in the first well, and
the first semiconductor region is electrically coupled to the source region.

24. The light detecting device according to claim 19, comprising a readout circuit including the amplification transistor and a selection transistor, and provided in the second substrate, the selection transistor configured to output the first signal, wherein
the selection transistor is provided outside the first separation region that is provided to surround the amplification transistor.

25. The light detecting device according to claim 19, wherein the first separation region and the second separation region are each configured using silicon oxide, and each have a quadrilateral shape.

26. The light detecting device according to claim 19, wherein the first separation region and the second separation region are each configured using polysilicon or silicon nitride.

27. The light detecting device according to claim 19, wherein the first separation region and the second separation region each have a shape having five or more straight lines, a circular shape, or an elliptical shape.

28. The light detecting device according to claim 19, further comprising a third substrate including a signal processing section that is configured to perform signal processing.

29. An electronic apparatus comprising:
an optical system; and
a light detecting device that receives light having passed through the optical system, wherein
the light detecting device includes
a first substrate including a plurality of photoelectric conversion elements that each photoelectrically converts light,
a second substrate stacked on the first substrate, and including a plurality of readout circuits that is each configured to output a first signal based on electric charge converted by the photoelectric conversion element,
a through electrode provided for each of the readout circuits or every plurality of the readout circuits in the second substrate, and configured to transmit the first signal, and
a first insulating layer provided to penetrate the second substrate around the through electrode.

30. An electronic apparatus comprising:
an optical system; and
a light detecting device that receives light having passed through the optical system, wherein
the light detecting device includes
a first substrate including a plurality of photoelectric conversion elements that each photoelectrically converts light,
a second substrate including a plurality of readout circuits, and stacked on the first substrate, the plurality of readout circuits each including an amplification transistor that is configured to generate a first signal based on electric charge converted by the photoelectric conversion element,
a through electrode provided for each of the readout circuits or every plurality of the readout circuits in the second substrate, and configured to transmit the first signal, and
an insulating layer provided to surround the amplification transistor in the second substrate.
